(19)

**Europäisches Patentamt**

**European Patent Office**

**Office européen des brevets**

(11) **EP 2 286 988 A1**

(12) **EUROPÄISCHE PATENTANMELDUNG**

(43) Veröffentlichungstag:
**23.02.2011  Patentblatt 2011/08**

(51) Int Cl.:
*B32B 3/30* *(2006.01)*  *B06B 1/02* *(2006.01)*
*H04R 17/02* *(2006.01)*  *H04R 23/00* *(2006.01)*
*H01L 41/08* *(2006.01)*  *H01L 41/083* *(2006.01)*
*H04R 17/00* *(2006.01)*

(21) Anmeldenummer: **09009203.2**

(22) Anmeldetag: **15.07.2009**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**AL BA RS**

(71) Anmelder: **Bayer MaterialScience AG**
**51368 Leverkusen (DE)**

(72) Erfinder:
• **Jenninger, Dr. Werner**
  **50677 Köln (DE)**
• **Wagner, Dr. Joachim**
  **51061 Köln (DE)**

• **Walze, Dr. Günther**
  **110 Taipei (TW)**
• **Schapeler, Dirk**
  **50171 Kerpen (DE)**
• **Pudleiner, Dr. Heinz**
  **47800 Krefeld (DE)**
• **Stollwerck, Dr. Gunther**
  **47802 Krefeld (DE)**
• **Gerhard, Prof. Dr. Reimund**
  **10623 Berlin (DE)**
• **Wirges, Werner, Dipl. Ing.**
  **14532 Kleinmachnow (DE)**
• **Altafim, Ruy Alberto**
  **Jd. Nova Santa Paula**
  **13564-330 Sao Carlos - SP (BR)**

(54) **Ferroelektret-Zwei- und Mehrschichtverbund und Verfahren zu dessen Herstellung**

(57)     Die vorliegende Erfindung betrifft ein Verfahren zur Herstellung von Zwei- oder Mehrschicht-Ferroelektreten mit definierten Hohlräumen durch: Strukturieren mindestens einer ersten Oberfläche einer ersten Polymerfolie (1) unter Ausbildung eines Höhenprofils, Auflegen mindestens einer zweiten Polymerfolie (5, 1') auf die in Schritt a) gebildete strukturierte Oberfläche der ersten Polymerfolie, Verbinden der Polymerfolien (1, 1', 5) zu einem Polyrnerfolienverbund unter Ausbildung von Hohlräumen (4, 4'), und die elektrische Aufladung der inneren Oberflächen der in Schritt c) ausgebildeten Hohlräume (4, 4') mit entgegengesetzten elektrischen Ladungen. Gegenstand der Erfindung sind weiterhin Ferroelektret-Mehrschichtverbunde, gegebenenfalls hergestellt nach den erfmdungsgemäßen Verfahren umfassend mindestens zwei übereinander angeordnete und miteinander verbundene Polymerfolien, wobei zwischen den Polymerfolien Hohlräume ausgebildet sind. Zudem betrifft die Erfindung ein piezoelektrisches Element enthaltend einen erfmdungsgemäßen Ferroelektret-Mehrschichtverbund.

FIG. 3a

EP 2 286 988 A1

## Beschreibung

Die vorliegende Erfmdung betrifft Verfahren zur Herstellung von Zwei- und Mehrschicht-Ferroelektreten mit definierten Hohlräumen und nach diesen Verfahren hergestellte Ferroelektret-Mehrschichtverbunde.

Wegen ihrer vorteilhaften und gezielt einstellbaren Eigenschaften, wie zum Beispiel geringes Gewicht, thermische Leitfähigkeit, mechanische Verformbarkeit, elektrische Eigenschaften sowie Barriereeigenschaften, werden Polymere und Polymerverbundstoffe in einer Vielzahl von kommerziellen Anwendungen eingesetzt. Sie werden beispielsweise als Verpackungsmaterial für Lebensmittel oder sonstige Güter, als Konstruktions- oder Isolationsmaterialien beispielsweise im Bauwesen oder im Fahrzeugbau verwendet. Funktionspolymere gewinnen in zunehmendem Maße aber auch als aktive Komponenten in Sensor- oder Aktoranwendungen an Bedeutung. Ein wichtiges Anwendungskonzept bezieht sich dabei auf den Einsatz der Polymere als elektromechanische oder piezoelektrische Wandler. Piezoelektrische Materialien sind in der Lage, einen mechanischen Druck linear in ein elektrisches Spannungssignal umzuwandeln. Umgekehrt kann ein an das piezoelektrische Material angelegtes elektrisches Feld in eine Änderung der Wandlergeometrie transformiert werden. Piezoelektrische Materialien werden bereits in einer Vielzahl von Anwendungen als aktive Komponenten integriert. Hierzu gehören beispielsweise strukturierte Drucksensoren für Tastaturen oder Touchpads, Beschleunigungssensoren, Mikrofone, Lautsprecher, Ultraschallwandler für Anwendungen in der Medizintechnik, der Meerestechnik oder zur Materialprüfung. In der WO 2006/053528 A1 ist beispielsweise ein elektroakustischer Wandler auf Basis eines piezoelektrischen Elements aus Polymerfolien beschrieben.

In den letzten Jahren steht zunehmend eine neue Klasse piezoelektrischer Polymere, die so genannten Ferroelektrete, im Interesse der Forschung. Die Ferroelektrete werden auch Piezoelektrete genannt. Ferroelektrete bestehen aus Polymermaterialien mit einer Hohlraumstruktur, die elektrische Ladungen über lange Zeiträume speichern können. Die bisher bekannten Ferroelektrete weisen eine zelluläre Hohlraumstruktur auf und sind entweder als geschäumte Polymerfolien oder als Mehrschichtsysteme aus Polymerfolien oder Polymergeweben ausgebildet. Sind elektrische Ladungen entsprechend ihrer Polarität auf den unterschiedlichen Oberflächen der Hohlräume verteilt, stellt jeder geladene Hohlraum einen elektrischen Dipol dar. Werden die Hohlräume nun deformiert, bedingt dies eine Änderung der Dipolgröße und führt zu einem Stromfluss zwischen äußeren Elektroden. Die Ferroelektrete können eine piezoelektrische Aktivität zeigen, die der anderer Piezoelektrika vergleichbar ist.

In der US 4,654,546 ist ein Verfahren zur Herstellung von Polypropylen-Schaumfolien als Vorstufe zu einer Ferroelektretfolie beschrieben. Hierbei werden die Polymerfolien mit Füllstoffpartikeln versetzt. Als Füllstoff wird zum Beispiel Titandioxid eingesetzt. Die Polypropylenfolien werden nach dem Extrudieren biaxial gereckt, so dass sich rund um die Füllstoffpartikel kleine Hohlräume in der Folie ausbilden. Dieses Verfahren wurde inzwischen auch auf andere Polymere angewendet. So wurde zum Beispiel in M. Wegener, M. Paajanen, O. Voronina, R. Schulze, W. Wirges, and R. Gerhard-Multhaupt "Voided cyclo-olefin polymer films: Ferroelectrets with high thermal stability", Proceedings, 12th International Symposium on Electrets (IEEE Service Center, Piscataway, New Jersey, USA 2005), 47-50 (2005) und Eetta Saarimäki, Mika Paajanen, Ann-Mari Savijärvi, and Hannu Minkkinen, Michael Wegener, Olena Voronina, Robert Schulze, Werner Wirges and Reimund Gerhard-Multhaupt "Novel Heat Durable Electromechanical Film: Processing for Electromechanical and Electret Applications", IEEE Transactions on Dielectrics and Electrical Insulation 13, 963-972 (October 2006), die Herstellung von Ferroelektretfolien aus Cyclo-Olefin-Copolymeren (COC) und Cyclo-Olefin-Polymeren (COP) beschrieben. Die geschäumten Polymerfolien haben den Nachteil, dass sich eine breite Verteilung der Bläschengröße ergeben kann. Dadurch können bei dem anschließenden Aufladungsschritt nicht alle Blasen gleichmäßig gut aufgeladen werden.

Ein weiteres Verfahren zur Herstellung geschäumter Ferroelektret-Polymerfolien ist das direkte physikalische Schäumen einer homogenen Folie mit superkritischen Flüssigkeiten, zum Beispiel mit Kohlendioxid. In Advanced Functional Materials 17, 324-329 (2007), Werner Wirges, Michael Wegener, Olena Voronina, Larissa Zirkel, and Reimund Gerhard-Multhaupt "Optimized preparation of elastically soft, highly piezoelectric, cellular ferroelectrets from nonvoided poly(ethylene terephthalate) films", und in Applied Physics Letters 90, 192908 (2007), P. Fang, M. Wegener, W. Wirges, and R. Gerhard L. Zirkel "Cellular polyethylene-naphthalate ferroelectrets: Foaming in supercritical carbon dioxide, structural and electrical preparation, and resulting piezoelectricity", ist dieses Verfahren mit Polyestermaterialien sowie in Applied Physics A: Materials Science & Processing 90, 615-618 (2008), O. Voronina, M. Wegener, W. Wirges, R. Gerhard, L. Zirkel, and H. Münstedt "Physical foaming of fluorinated ethylene-propylene (FEP) copolymers in supercritical carbon dioxide: single film fluoropolymer piezoelectrets" für ein Fluorpolymer FEP (Fluorinated Ethylene-Propylene Copolymer) beschrieben worden.

Bei den Ferroelektret-Mehrschichtsystemen sind unter anderem Anordnungen aus harten und weichen Schichten und dazwischen eingebrachten Ladungen bekannt. In "Double-layer electret transducer", Journal of Electrostatics, Vol. 39, pp. 33-40, 1997, R. Kacprzyk, A. Dobrucki, and J. B. Gajewski, sind Mehrfachschichten aus festen Materialien mit stark unterschiedlichen Elastizitätsmodulen beschrieben. Diese haben den Nachteil, dass diese Schichtsysteme nur einen relativ geringen piezoelektrischen Effekt zeigen.

In mehreren Veröffentlichungen aus den letzten Jahren sind Mehrschichtsysteme aus geschlossenen äußeren Schichten und einer porösen oder perforierten Mittelschicht beschrieben. Hierzu gehören die Artikel von Z. Hu and H. von Seggern, "Air-breakdown charging mechanism of fibrous polytetrafluoroethylene films", Journal of Applied Physics, Vol. 98, paper 014108, 2005 und "Breakdown-induced polarization buildup in porous fluoropolymer sandwiches: A thermally stable piezoelectret", Journal of Applied Physics, Vol. 99, paper 024102, 2006, sowie die Veröffentlichung von H.C. Basso, R.A.P. Altafilm, R.A.C. Altafilm, A. Mellinger, Peng Fang, W. Wirges, and R. Gerhard "Three-layer ferroelectrets from perforated Teflon-PTFE films fused between two homogeneous Teflon -FEP films" IEEE, 2007 Annual Report Conference on Electrical Insulation and Dielectric Phenomena, 1-4244-1482-2/07, 453-456 (2007) und der Artikel von Jinfeng Huang, Xiaoqing Zhang, Zhongfu Xia, and Xuewen Wang "Piezoelectrets from laminated sandwiches of porous polytetrafluoroethylene films and nonporous fluoroethylenepropylene films" Journal of Applied Physics, Vol. 103, paper 084111, 2008. Die Schichtsysteme mit einer porösen oder perforierten Mittelschicht haben gegenüber den vorstehend beschriebenen Systemen häufig größere Piezokonstanten. Dabei lassen sich die Mittelschichten jedoch manchmal nicht zuverlässig mit den festen Außenschichen laminieren. Darüber hinaus ist die Perforation der Mittelschicht in der Regel sehr zeitaufwendig.

In den Veröffentlichungen von X. Zhang, J. Hillenbrand und G. M. Sessler, "Thermally stable fluorocarbon ferroelectrets with high piezoelectric coefficient". Applied Physics A, Vol. 84, pp. 139-142, 2006 und "Ferroelectrets with improved thermal stability made from fused fluorocarbon layers", Journal of Applied Physics, Vol. 101, paper 054114, 2007, sowie in Xiaoqing Zhang, Jinfeng Huang and Zhongfu Xia "Piezoelectric activity and thermal stability of cellular fluorocarbon films" PHYSICA SCRIPTA Vol. T129 pp 274-277, 2007 ist die Strukturierung der Polymerschichten durch Aufdrücken eines Metallgitters auf einen Polymerschichtstapel aus mindestens drei in alternierender Reihenfolge übereinander gelagerten FEP- und PTFE-Schichten beschrieben. Durch das Zusammenpressen der Schichten durch das Gitter bei einer Temperatur, die über dem Schmelzpunkt von FEP und unter dem von PTFE liegt, werden die Polymerschichten entsprechend der Gitterstruktur derart miteinander verbunden, dass sich zwischen den Gitterstäben kuppelförmige oder blasenförmige Hohlräume mit rechteckiger Grundfläche bilden. Dieses Verfahren führt jedoch zu Ferroelektreten mit unterschiedlicher Qualität, da die Bildung gleichförmiger Hohlräume vor allem bei zunehmender Schichtenanzahl nur schwer kontrolliert werden kann.

Ein anderes Verfahren zur Herstellung blasenförmiger Hohlräume unter Verwendung eines Gitters ist durch R. A. C. Altafim, H. C. Basso, R. A. P. Altafim, L. Lima, C. V. De Aquino, L. Gonalves Neto and R. Gerhard-Multhaupt, in "Piezoelectrets from thermo-formed bubble structures of fluoropolymer-electret films", IEEE Transactions on Dielectrics and Electrical Insulation, Vol. 13, No.5, pp. 979-985, 2006 beschrieben worden. Hierbei werden zwei übereinander angeordnete Teflon-FEP-Folien zwischen einem Metallgitter und einem oberen zylinderförmigen Metallteil angeordnet. Dieser Aufbau wird mit dem Metallgitter auf ein unteres zylinderförmiges Metallteil aufgepresst, welches Öffnungen zur Anlegung eines Vakuums aufweist. Die FEP-Folien werden durch das obere Metallteil erhitzt und durch ein an das untere Metallteil angelegtes Vakuum wird die untere Folie in die Öffnungen des Gitters gezogen und entsprechende Hohlräume gebildet. Die beschriebenen Verfahren unter Verwendung eines Gitters zur Ausbildung von Hohlräumen in den Polymer-Mehrschichtverbunden sind aufwendig und schwierig in den großtechnischen Maßstab zu übertragen.

Eine vorteilhaft einfache Herstellungsmethode für Ferroelektrete mit röhrenförmigen Hohlräumen homogener Größe und Struktur wurde von R. A. P. Altafim, X. Qiu, W. Wirges, R. Gerhard, R. A. C. Altafim, H.C. Basso, W. Jenninger und J. Wagner in dem Artikel "Template-based fluoroethylenepropylene piezoelectrets with tubular channels for transducer applications", akzeptiert zur Publikation im Journal of Applied Physics, beschrieben. Bei dem dort beschriebenen Verfahren wird zunächst eine Sandwichanordnung zweier FEP-Folien und einer dazwischen eingelegten PTFE-Maskenfolie bereitgestellt. Der gebildete Folienstapel wird laminiert, die FEP-Folien miteinander verbunden und nachfolgend die Maskenfolie unter Freigabe der Hohlräume entfernt.

Ferroelektrete sind für kommerzielle Anwendungen, beispielsweise für Sensor-, Aktor- und Generatorsysteme, weiterhin von zunehmendem Interesse. Für die Wirtschaftlichkeit ist dabei eine Anwendbarkeit eines Herstellungsverfahrens im industriellen Maßstab essentiell.

Der Erfmdung liegt daher die Aufgabe zu Grunde, alternative Ferroelektret-Mehrschichtverbunde sowie alternative Verfahren zur Herstellung von Ferroelektret-Mehrschichtverbunden bereit zustellen, mit denen definierte Ferroelektret-Hohlraumstrukturen erzeugt werden können und die einfach und kostengünstig auch im großtechnischen und industriellen Maßstab durchführbar sind.

Diese Aufgabe wird erfindungsgemäß durch das Verfahren zur Herstellung von Ferroelektret-Mehrschichtverbunden gemäß Anspruch 1 und einem nach diesem Verfahren hergestellten Ferroelektret-Mehrschichtverbund gemäß Anspruch 13 gelöst.

Erfindungsgemäß wird ein Verfahren zur Herstellung eines Ferroelektret- Zwei- oder Mehrschichtverbunds mit definierten Hohlräumen vorgeschlagen, das die folgenden Schritte umfasst:

a) Strukturieren mindestens einer ersten Oberfläche mindestens einer ersten Polymerfolie unter Ausbildung eines Höhenprofils,

b) Auflegen mindestens einer zweiten Polymerfolie auf die in Schritt a) gebildete strukturierte Oberfläche der ersten Polymerfolie,

c) Verbinden der Polymerfolien zu einem Polymerfolienverbund unter Ausbildung von geschlossenen und/oder offenen Hohlräumen und

d) Elektrische Aufladung der inneren Oberflächen der in Schritt c) ausgebildeten Hohlräume mit entgegengesetzten elektrischen Ladungen.

Die erfmdungsgemäß hergestellten Zwei- und Mehrschichtverbunde weisen mit anderen Worten stapelförmig geschichtete Polymerfolien und mindestens zwischen jeweils zwei Polymerfolien ausgebildete Hohlräume auf. Die Polymerfolien sind dabei zwischen den Hohlräumen miteinander verbunden. Vorteilhafterweise können die Form und Dimensionierung der Hohlräume erfindungsgemäß sehr genau vorbestimmt und definiert hergestellt werden. Die Strukturierung in Schritt a) und die Ausbildung des Höhenprofils auf mindestens einer Oberfläche mindestens der ersten Polymerfolie ist im erfindungsgemäßen Verfahren dabei maßgeblich für die Ausbildung der definierten Hohlräume im entstehenden Polymerfolienverbund.

Es wurde gefunden, dass mit dem erfindungsgemäßen Verfahren auf einfache Weise Ferroelektret-Mehrschicht-Systeme mit definierten Hohlraumstrukturen hergestellt werden können. Mit der erfindungsgemäßen Vorgehensweise ist es außerdem möglich, Resonanzfrequenz und Piezoaktivität, und insbesondere die piezoelektrische Konstante d33, auf die jeweilige Anwendung variabel einzustellen. Vorteilhafterweise können mit den erfindungsgemäß hergestellten Ferroelektret-Mehrschichtverbund-Systemen hohe und gleichmäßige piezoelektrische Koeffizienten auch für größere Flächen erzielt werden. Dies erschließt diesen Ferroelektret-Mehrschichtverbunden grundsätzlich zahlreiche Anwendungen. Ein zusätzlicher Vorteil ist, dass die erfmdungsgemäß vorgeschlagenen Prozesse weitgehend materialunabhängig und automatisierbar sind.

Grundsätzlich können die eingesetzten Polymerfolien aus jedem Kunststoff gefertigt sein, der eine Ausbildung eines Höhenprofils, die Verbindung zwischen den Polymerfolien und eine Ausbildung von Hohlräumen zwischen den Folien erlaubt. Die eingesetzten Polymerfolien können erfmdungsgemäß aus gleichen oder unterschiedlichen Polymermaterialien, beispielsweise aus der Gruppe der Polycarbonate, perfluorierten oder teilfluorierten Polymere und - Copolymere wie PTFE, Fluorethylenpropylen (FEP), Perfluoralkoxyethylenen (PFA), Polyestern wie Polyethylenterephthalat (PET) oder Polyethylennaphthalat (PEN), Cyclo-Olefin-Polymere, Cyclo-Olefin-Copolymere, Polyimiden, insbesondere Polyetherimid, Polyethern, Polymethylmethacrylat und Polypropylen oder Polymerblends hieraus ausgewählt sein. Mit diesen Materialien können gute bis sehr gute Piezoaktivitäten erzielt werden. Die erfmdungsgemäß breite Materialauswahl kann vorteilhafterweise auch eine Anpassung auf bestimmte Anwendungen ermöglichen.

Die Polymerfolien können bevorzugt eine Dicke von $\geq 10 \ \mu m$ bis $\leq 500 \ \mu m$, besonders bevorzugt von $\geq 15 \ \mu m$ bis $\leq 300 \ \mu m$ aufweisen. Die Dicke der verschiedenen Polymerfolien in einem erfmdungsgemäßen Ferroelektret-Mehrschichtverbund kann dabei gleich oder unterschiedlich gewählt werden. Eine besonders geeignete Dicke der Polymerfolien kann dabei vorteilhafterweise jeweils in Abhängigkeit des Polymermaterials und im Hinblick auf die angestrebte Anwendung ausgewählt werden. Es kommt grundsätzlich darauf an, dass die in Schritt c) des Verfahrens ausgebildeten Hohlräume nicht kollabieren. So können steifere Materialien dünner ausgeführt werden als vergleichsweise elastischere Polymermaterialien.

Die Polymerfolien können als Folienblätter oder insbesondere im Hinblick auf eine großtechnische Herstellung vorteilhafterweise auch als Folienbahnen ausgestaltet sein, die in Schritt b) übereinander angeordnet und unter Ausbildung der Hohlräume in Schritt c) miteinander verbunden werden können. Die Folienblätter können dabei beispielsweise eine rechteckige, eine regelmäßige oder unregelmäßige Vieleckform oder eine runde, beispielsweise kreisförmige, elliptische oder ovale Grundfläche aufweisen, wobei die übereinander angeordneten Folien zweckmäßigerweise, zumindest im übereinander angeordneten Bereich, die gleiche Grundfläche aufweisen. Grundsätzlich kann die Grundfläche auch an eine spezielle Anwendung angepasst werden.

In Schritt b) des erfindungsgemäßen Verfahrens wird mit anderen Worten ein geschichteter Polymerfolienstapel bereitgestellt. Hierbei können über die gewählte Gesamtzahl der Polymerfolien und der gewählten Abfolge strukturierter und nicht strukturierter Polymerfolien die Gesamthöhe des Polymerfolienverbunds und die Anzahl der Hohlräume und die Anzahl der Lagen mit Hohlräumen festgelegt werden. Als eine Lage von Hohlräumen werden die Hohlräume zwischen zwei gleichen Polymerfolien verstanden. In den erfindungsgemäßen Ferroelektret-Mehrschichtverbunden können zwei, drei oder mehr Polymerfolien mit zwischen liegenden Hohlräumen übereinander angeordnet und miteinander verbunden sein. Erfindungsgemäß können dabei jeweils strukturierte und nicht strukturierte Polymerfolien eingesetzt werden. Diese können zum Beispiel alternierend im Folienstapel übereinander angeordnet werden. Alternativ können auch alle eingesetzten Polymerfolien ein Höhenprofil, also eine Strukturierung, aufweisen. Es können gleichermaßen bevorzugt auch nur einseitig oder nur beidseitig strukturierte Polymerfolien verwendet werden oder beide Folienarten in gleicher oder unterschiedlicher Anzahl. Grundsätzlich ist bei allen Varianten bevorzugt, dass die nach außen gerichteten Oberflächen kompakt oder nicht strukturiert sind. Dies kann gegebenenfalls die Aufbringung von Elektroden auf diesen Außenflächen des Polymerfolienverbunds vereinfachen. Bei der Verwendung von zweiseitig strukturierten Polymerfolien kann beispielsweise zu diesem Zweck zusätzlich eine nicht- oder eine einseitig strukturierte Polymerfolie jeweils im Polymerfolienstapel oben und unten als Abschlussfolie angeordnet werden Diese Abschlussfolien bilden als Abdeckung mit ihrer nicht strukturierten Oberfläche die Außenfläche des nachfolgend gebildeten Polymerfolienverbunds. Vorteilhafterweise können die erfmdungsgemäßen Varianten, in denen drei oder mehr Polymerfolien und entsprechend auch mehrere Lagen von Hohlräumen im Ferroelektret-Mehrschichtverbund vorgesehen werden, gegenüber denen mit nur zwei Polymerfolien weicher gestaltet und durch die zusätzlichen vorhandenen Hohlräume die Empfmdlichkeit des Verbunds und damit die Piezoelektrische Konstante d33 erhöht werden.

In Schritt d) kann für die elektrische Aufladung und Polung der inneren Oberflächen der Hohlräume vorteilhafterweise auf bekannte und etablierte Methoden zurückgegriffen werden. Eine polung der sich gegenüberliegenden Seiten der Hohlräume kann beispielsweise durch eine Corona-Entladung oder durch Plasmaverfahren realisiert werden. Eine Corona-Behandlung ist vorteilhafterweise auch großtechnisch gut einsetzbar.

Durch die in Schritt a) durchgeführte Strukturierung und Ausbildung des Höhenprofils in einer Polymerfolie und die Verbindung mit mindestens einer zweiten Polymerfolie in Schritt b) können mit dem bereitgestellten Verfahren genau vorbestimmte Hohlräume erzeugt und definiert hergestellt werden. Ein weiterer Vorteil ist daher, dass mit der erfindungsgemäßen Vorgehensweise unterschiedliche Resonanzfrequenzen, wie sie bei geschäumten Ferroelektret-Folien unkontrolliert durch ungleichförmige Blasen auftreten, vermieden werden können. Im Gegensatz dazu ist es erfindungsgemäß sogar möglich, auch in Teilbereichen des entstehenden Polymerfolienverbunds unterschiedlich ausgestaltete Hohlräume zu erzeugen und damit unterschiedliche Eigenschaften, beispielsweise Piezoaktivitäten, einzustellen.

In einer Ausführungsform kann die Strukturierung der mindestens einen Oberfläche der ersten Polymerfolie in Schritt a) durch einen Prägeprozess erfolgen. Gleichermaßen bevorzugt kann der Prägeprozess unter Verwendung einer strukturierten Walze oder mittels eines Prägestempels erfolgen. Sowohl bei Einsatz einer strukturierten Walze, als auch bei eingesetztem strukturiertem Prägestempel kann jeweils die auf der Oberfläche des Prägewerkzeugs ausgebildete Struktur unter Ausbildung eines Höhenprofils auf eine Polymerfolie übertragen werden. Es ist dabei möglich, auf der Oberfläche des Prägewerkzeugs, also der Walze oder des Prägestempels, Positiv- oder Negativformen aufzubringen. Die Strukturierung kann direkt nach der Extrusion der Folien oder auch als Einzelprozess, beispielsweise in einer Heißpresse, erfolgen. Erfindungsgemäß umfasst ist auch, dass die jeweiligen Polymerfolien von beiden Oberflächenseiten mit einem Prägewerkzeug bearbeitet werden können. Beispielsweise kann eine Polymerfolie von ihrer Ober- und ihrer Unterseite mit jeweils einer strukturierten Walze geprägt und damit strukturiert werden.

In einer anderen alternativen Ausgestaltung des Verfahrens kann die Strukturierung der mindestens einen Oberfläche der ersten Polymerfolie in Schritt a) durch Verformung einer gegebenenfalls erwärmten Polymerfolie unter Druckbeaufschlagung, beispielsweise mit Druckluft oder einem anderen Gas, in einem Formwerkzeug mit einem gegebenenfalls vortemperierten Kontureinsatz erfolgen. Beispielsweise kann eine Polymerfolie auf eine Temperatur unterhalb ihrer Erweichungstemperatur (Glasübergangstemperatur) erwärmt und dann schlagartig durch Beaufschlagung mit Pressluft von ≥20 bis ≤300 bar verformt werden. Beispielsweise können Polycarbonatfolien (zum Beispiel Macrofol der Bayer MaterialScience AG) knapp unter die Glastemperatur auf 130-140 °C erwärmt werden. Danach können die Folien mit einem Luftdruck von 250 bar beaufschlagt und auf ein Formwerkzeug gepresst werden und können sich der Werkzeugkontur anpassen und dauerhaft verformt werden. Hierbei können die eingesetzten Polymerfolien beispielsweise eine Dicke von ≥10 µm bis ≤500 µm und die gebildeten Vertiefungen und/oder Erhebungen eine Höhe von ≥10 µm bis ≤500 µm, sowie eine Breite von ≥10 µm bis ≤5000 µm aufweisen. Bevorzugt ist für die Hohlräume eine Höhe von ≥10um ≤250 µm und eine Breite von ≥50µm bis ≤3000 µm. Besonders bevorzugt haben die Hohlräume eine Breite von ≥100 µm bis ≤2000 µm.

Ein analoges Verfahren ist insbesondere bei der wiederholgenauen Verformung von bedruckten Kunststoff-Folien bereits etabliert und beispielsweise in der Offenlegungsschrift DE 39 05 177 A1 beschrieben. Eine Polymerfolie kann dabei auf einem Palettensystem positioniert, bei Bedarf erwärmt und in einem entsprechenden Formwerkzeug über einem vortemperierten Kontureinsatz durch Druckbeaufschlagung verformt werden. Dieser Hochdruckverformungsprozess wird auch als High Pressure Forming (HPF); oder HPF-Prozess bezeichnet. Vorteilhafterweise kann erfindungsgemäß auch eine analog aufgebaute Vorrichtung zu der in der DE 39 05 177 A1 beschriebenen, zur Strukturierung der Polymerfolien in Schritt a) eingesetzt werden.

Alle genannten Strukturierungsvarianten haben den Vorteil, dass positionsgenau die Übertragung des jeweils gewünschten Profils auf die Polymerfolien ermöglicht wird. Sowohl Form als auch Dimensionierung der dann im nächsten Schritt b) ausgebildeten Hohlräume ist mit den vorstehend genannten Methoden vorteilhafterweise nahezu frei wählbar und kann in Abhängigkeit mit den Folienmaterialen und deren Eigenschaften und der jeweiligen Foliendicke auf die gewünschten mechanischen und elektrischen Anforderungen der jeweiligen Anwendung angepasst werden. Die Kombination der Folieneigenschaften und der Form und Dimensionierung der ausgebildeten Hohlräume wird dabei so gewählt, dass die auf Abstand zu haltenden Folienabschnitte sich in keinem Nutzungsfall berühren können. Die genannten Strukturierungsmethoden haben weiterhin den Vorteil, dass sie automatisierbar sind und gegebenenfalls als kontinuierlicher Prozess durchgeführt werden können.

Erfindungsgemäß kann die Strukturierung der mindestens einen Oberfläche der ersten Polymerfolie in Schritt a) auch durch Schlitzextrusion der Polymerfolie mit entsprechend geformter Düse erfolgen. Beispielsweise können durch Anwendung dieser Strukturierungsmethode röhren- oder kanalartige Strukturen und nachfolgend in einem Schritt entsprechende Hohlräume ausgebildet werden. Die Schlitzextrusion ist dabei vorteilhafterweise ein bereits etablierter Prozess, der darüber hinaus ebenfalls kontinuierlich und automatisiert durchgeführt werden kann.

In einem erfindungsgemäß hergestellten Ferroelektret-Mehrschichtverbund können die Hohlräume bei einer Polymerfoliendicke von $\geq 10$ $\mu$m bis $\leq 500$ $\mu$m beispielsweise eine Höhe von $\geq 10$ $\mu$m bis $\leq 500$ $\mu$m aufweisen. Mit der Höhe ist insbesondere die Höhe der Hohlräume im Querschnitt gemeint. Besonders bevorzugt können die Hohlräume eine Höhe von $\geq 10$ $\mu$m bis $\leq 250$ $\mu$m aufweisen.

Die Hohlräume können durch das erfindungsgemäße Verfahren in zahlreichen unterschiedlichen Formen ausgebildet werden. Die Form der Hohlräume ist daher nicht auf eine zylindrische, röhrenförmige oder kanalartige Form mit einer kreisförmigen oder rechteckigen Querschnittsfläche senkrecht zum Schichtverlauf der Polymerfolien beschränkt. Darüber hinaus bietet das erfindungsgemäße Verfahren die Möglichkeit, in unterschiedlichen Formen ausgebildete Hohlräume zu kombinieren. Auf diese Weise kann zum einen vorteilhafterweise das Gesamthohlraumvolumen der resultierenden Hohlräume maximiert werden. Zum anderen können die elektromechanischen, insbesondere piezoelektrischen, Eigenschaften der mit dem erfindungsgemäßen Verfahren hergestellten Ferroelektret-Mehrschichtverbunde und elektromechanischen Wandler durch Auswahl der Hohlraumform, -größe, und -gestalt, ihrer Anzahl, Anordnung und/oder Verteilung angepasst werden.

Die Hohlräume können in Formen mit einer eher geringen Fläche, wie Linien, beispielsweise gebogene oder gerade, einzelne oder gekreuzte Linien beziehungsweise Umfangslinien von geometrischen Figuren, etwa einer Kreislinie oder einer Umfangslinie eines Kreuzes, oder als Strukturen mit einer größeren Fläche, wie Rechtecke, Kreise, Kreuze, et cetera, ausgebildet werden. Die Form und Dimensionierung der Hohlräume wird vorzugsweise derart eingestellt, dass sich die Polymerfolien, senkrecht zu deren Schichtverlauf innerhalb des Hohlraums nicht berühren können und/oder dass das nach Fertigstellung resultierende Gesamthohlraumvolumen möglichst groß ist. Mit anderen Worten sollen sich insbesondere die durch Polung auf die inneren Oberflächen der Hohlräume aufgebrachten positiven und negativen Ladungen nicht berühren können.

Die Hohlräume können in Formen ausgebildet sein, welche eine Querschnittsfläche, ausgewählt aus der Gruppe bestehend aus im Wesentlichen runden, beispielsweise kreisförmigen, elliptischen oder ovalen, polygonen, beispielsweise dreieckigen, rechteckigen, trapezförmigen, rautenförmigen, fünfeckigen, sechseckigen, insbesondere wabenförmigen, kreuzförmigen, sternförmigen und teilweise runden und teilweise polygonen, beispielsweise S-förmigen, Querschnittsflächen, aufweisen. Die Hohlräume in verschiedenen Lagen zwischen den verschiedenen Polymerfolien im Folienstapel können dabei gleich oder unterschiedlich ausgestaltet sein. Dies umfasst sowohl deren Form, Größe und Gestalt als auch die Anzahl der Hohlräume, ihre Anordnung und/oder Verteilung.

Die Hohlräume innerhalb des gebildeten Polymerfolienverbunds können den herzustellenden Ferroelektret-Mehrschichtverbund vorteilhafterweise entlang seiner Dicke weicher machen, damit dessen Elastizitätsmodul erniedrigen, sowie einen Polungsprozess in den resultierenden Hohlräumen ermöglichen.

Im Rahmen des erfindungsgemäßen Verfahrens können die Hohlräume im gebildeten Polymerfolienverbund sowohl homogen als auch heterogen verteilt ausgebildet sein. Insbesondere kann es in Abhängigkeit vom Anwendungsbereich des herzustellenden Ferroelektret-Mehrschichtverbunds auch vorteilhaft sein, die Hohlräume gezielt, ortsaufgelöst heterogen verteilt auszubilden.

Das Verbinden der Polymerfolie zu einem Polymerfolienverbund in Schritt c) kann erfindungsgemäß beispielsweise durch Laminieren, Kleben, Klammern, Klemmen, Schrauben oder Nieten erfolgen.

Die Verbindung der Polymerfolien durch Laminieren kann insbesondere thermisch, unter erhöhtem Druck und/oder mittels Ultraschall und/oder mittels Bestrahlung mit Ultraviolettem Licht oder Infrarot-Licht durchgeführt werden. Hierdurch kann vorteilhafterweise die Materialauswahl für die Polymerfolien noch vergrößert werden. Die Bedingungen für die Laminierung werden dabei zweckmäßigerweise so gewählt, dass die Folienschichten sich verbinden, die Strukturierung der ersten Polymerfolie und deren Höhenprofil dabei jedoch weitestgehend erhalten bleiben und so eine Formbeständigkeit und definierte Ausbildung der Hohlräume sichergestellt wird. Vor dem Laminieren kann das Material der ersten strukturierten Polymerfolie und/oder das Material der zweiten Polymerfolie, die auch mit anderen Worten eine Abdeckung der ersten Folie bildet, vollständig verfestigt, beispielsweise vollständig getrocknet und/oder vollständig vernetzt, und /oder vollständig erstarrt und/oder vollständig kristallisiert werden. Hierdurch kann die Formbeständigkeit des verfahrensgemäß entstehenden, Hohlräume umfassenden Polymerfolienverbunds verbessert werden.

Die Verbindung der Polymerfolien in Schritt c) mittels einer Klebung kann beispielsweise mit Acrylatkleber erfolgen. Alternativ ist es auch möglich, insbesondere bei der Verbindung von Polymerfolien aus gleichem Material, die Verbindung durch Aufbringen eines guten Lösungsmittels oder einer Lösungsmittelzusammensetzung für das jeweilige Polymermaterial auf eine oder beide Folien, nachfolgendes Zusammendrücken der Folien und Verdunsten des Lösungsmittels zu erzielen. Mit anderen Worten wird das Polymermaterial an den Stellen und/oder Bereichen an denen das Lösungsmittel aufgetragen wurde angelöst und durch die Verdunstung des Lösungsmittel wieder ausgehärtet und kann auf diese Weise als Klebemasse zwischen den Polymerfolien dienen. Es ist zum Beispiel möglich Polycarbonatfolien mit Methylenchlorid zu verkleben. Vorteil bei der Verbindung durch diese Lösungsmittel-Methode ist, dass keine thermische Belastung auftritt und gerade bei thermisch verformbaren Polymermaterialien die Formbeständigkeit verbessert und ein Kollabieren der ausgebildeten Hohlräume vermieden werden kann.

In einer weiteren Ausgestaltung können die Polymerfolien auch zusätzlich zur Laminierung durch eine Verklebung miteinander verbunden werden. Diese Verklebung kann beispielsweise mittels Acrylatkleber hergestellt werden. Hierdurch kann die mechanische Verbindung der Polymerfolien unterstützt und verbessert werden.

In einer anderen Ausgestaltung des Verfahrens kann vor und/oder nach der elektrischen Aufladung der inneren Oberflächen der Hohlräume in Schritt d) die Aufbringung von Elektroden an den äußeren Oberflächen des Polymerfolienverbunds erfolgen. Unter der Aufbringung von Elektroden an den äußeren Oberflächen wird die Bereitstellung einer leitenden Oberflächenbeschichtung in mindestens einem Teilbereich, insbesondere auf den nach außen gerichteten Oberflächen des Polymerverbunds verstanden. Die Elektroden werden bevorzugt auf kompakten oder nichtstrukturierten Oberflächen der eingesetzten Polymerfolien angeordnet.

Erfindungsgemäß kann nach der Aufbringung von Elektroden auf den äußeren Oberflächen des Ferroelektret-Mehrschichtverbunds eine direkte Aufladung durch Anlegung einer elektrischen Spannung erfolgen. Vor der Aufbringung von Elektroden kann eine Polung der sich gegenüberliegenden Seiten der Hohlräume beispielsweise durch eine Corona-Entladung realisiert werden. Eine Corona-Behandlung ist vorteilhafterweise auch großtechnisch gut einsetzbar. Erfindungsgemäß ist es auch möglich, zunächst auf einer Oberfläche eine leitende Oberflächenbeschichtung bereitzustellen, den Polymerverbund dann aufzuladen und abschließend eine zweite Elektrode auf der gegenüberliegenden äußeren Oberfläche aufzubringen.

Mit anderen Worten können die erfindungsgemäß hergestellten Ferroelektret-Mehrschichtverbunde auf den nach außen gerichteten Oberflächen der Polymerfolien mindestens teilweise eine leitende Beschichtung aufweisen. Diese leitenden Bereiche können als Elektroden genutzt werden. Die leitende Beschichtung, das heißt die Elektroden, können dabei flächig und/oder auch strukturiert aufgebracht werden. Eine strukturierte leitende Beschichtung kann beispielsweise als eine Aufbringung in Streifen oder in Gitterform ausgestaltet sein. Hierdurch kann zusätzlich die Empfmdlichkeit des Ferroelektret-Mehrschichtverbunds beeinflusst und auf bestimmte Anwendungen angepasst werden.

Bei den ausgewählten Elektrodenmaterialien kann es sich um dem Fachmann bekannte leitfähige Materialien handeln. Erfindungsgemäß kommen hierfür beispielsweise Metalle, Metall-Legierungen, leitfähige Oligo- oder Polymere, wie z.B. Polythiophene, Polyaniline, Polypyrrole, leitfähige Oxide, wie z.B. Mischoxide wie ITO, oder mit leitfähigen Füllstoffen gefüllte Polymere in Frage. Als Füllstoffe für mit leitfähigen Füllstoffen gefüllte Polymere kommen beispielsweise Metalle, leitfähige Kohlenstoff basierte Materialien, wie z.B. Russ, Kohlenstoffnanoröhrchen (Carbonanotubes (CNTs)) oder wiederum leitfähige Oligo- oder Polymere, in Frage. Der Füllstoffgehalt der Polymere liegt dabei oberhalb der Perkolationsschwelle, so dass die leitfähigen Füllstoffe durchgehende elektrisch leitfähige Pfade ausbilden.

Die Elektroden können durch an sich bekannte Verfahren, beispielsweise durch eine Metallisierung der Oberflächen, durch Sputtern, Aufdampfen, Chemical Vapor Deposition (CVD), Drucken, Rakeln, Lackschleudern (Spin-Coating), Aufkleben oder Aufdrücken einer leitenden Schicht in vorgefertigter Form oder durch eine Sprühelektrode aus einem leitenden Kunststoff realisiert werden. Die Elektroden können dabei strukturiert, beispielsweise in Streifen oder in Gitterform, ausgestaltet sein. Beispielsweise können erfmdungsgemäß die Elektroden auch derart strukturiert sein, dass der Ferroelektret-Mehrschichtverbund als elektromechanischer Wandler aktive und passive Bereiche aufweist. Insbesondere können die Elektroden derart strukturiert sein, dass, insbesondere in einem Sensor-Modus, die Signale ortsaufgelöst detektiert und/oder, insbesondere in einem Aktuator-Modus, die aktiven Bereiche gezielt angesteuert werden können. Dies kann beispielsweise dadurch erzielt werden, dass die aktiven Bereiche mit Elektroden versehen sind, wohingegen die passiven Bereiche keine Elektroden aufweisen.

Erfindungsgemäß umfasst ist auch, dass zwei oder mehr Ferroelektret-Mehrschichtverbunde mit gleich gepolter leitender Schicht, das heißt also Elektrode, verbunden werden können. Mit anderen Worten kann zwischen zwei erfmdungsgemäßen Ferroelektret Mehrschichtverbunden eine Zwischenelektrode gebildet werden, die gegen die beiden Elektroden auf den dann äußeren Oberflächen geschaltet werden kann. Hierdurch können die Ferroelektret-Mehrschichtverbunde in Reihe geschaltet und der erzielbare piezoelektrische Effekt verdoppelt, bzw. vervielfacht werden.

Die erfindungsgemäßen Ferroelektret-Mehrschichtverbunde enthalten bevorzugt zwei Elektroden. Bei erfmdungsgemäßen elektromechanischen Wandlern mit mehr als zwei Elektroden kann es sich beispielsweise um Stapelaufbauten aus mehreren, vorzugsweise erfindungsgemäß hergestellten, Ferroeletkret-Mehrschichtverbund-Systemen handeln.

In einer anderen Ausgestaltung des erfmdungsgemäßen Verfahrens können die Schritte a), b), c) und/oder d) als kontinuierlicher Rolle-zu-Rolle Prozess durchgeführt werden. Vorteilhafterweise kann die Herstellung der Mehrschichtverbunde also mindestens teilweise als kontinuierlicher Prozess, vorzugsweise als Rolle-zu-Rolle Prozess, durchgeführt werden. Dies ist besonders vorteilhaft für die Anwendung der Verfahren im großtechnischen und industriellen Maßstab. Die Automatisierung zumindest eines Teils der Herstellungsverfahren vereinfacht die Verfahren und ermöglicht die kostengünstige Produktion der Ferroelektret-Mehrschichtverbunde mit Hohlräumen. Erfindungsgemäß sind vorteilhafterweise alle Schritte des Verfahrens einer Automatisierung zugänglich.

In einer Ausführungsform der Erfindung kann vor Schritt b) auch die zweite Polymerfolie unter Ausbildung eines Höhenprofils strukturiert werden. Hierdurch kann die Variabilität der erzeugbaren Ferroelektret-Mehrschichtverbunde noch erhöht werden. Über die gewählte Gesamtzahl der Polymerfolien und der gewählten Abfolge strukturierter und nicht strukturierter Polymerfolien kann die Gesamthöhe und die Anzahl der Hohlräume, bzw. Anzahl der Lagen mit Hohlräumen festgelegt werden. In den erfindungsgemäßen Ferroelektret-Mehrschichtverbunden können damit zwei, drei oder mehr Polymerfolien mit zwischen liegenden Hohlräumen übereinander angeordnet und miteinander verbunden sein. Beispielsweise können strukturierte und nicht strukturierte Polymerfolien alternierend im Folienstapel übereinander angeordnet werden. Alternativ können auch alle eingesetzten Polymerfolien ein Höhenprofil aufweisen, wobei die Folien zueinander eine gleiche oder auch eine unterschiedliche Strukturierung aufweisen können.

In einer anderen Ausgestaltung ist in einem weiteren Schritt e) vor oder nach der Aufladung in Schritt d) das Versiegeln der Kanten des in Schritt c) gebildeten Polymerfolienverbunds umfasst. Die erfindungsgemäßen Mehrschichtverbunde können damit vorteilhafterweise an den Rändern versiegelt werden, um diese hermetisch vor Umwelteinflüssen zu schützen, z. B. bei Anwendungen in einer aggressiven Umgebung, beispielsweise bei Atmosphären mit hoher Luftfeuchtigkeit oder unter Wasser.

In einer weiter bevorzugten Ausführungsform der Erfindung kann in die Hohlräume ein Gas eingefüllt werden. Das Gas kann dabei beispielsweise reiner Stickstoff ($N_2$), Stickstoffoxid ($N_2O$) oder Schwefelhexafluorid ($SF_6$) sein. Durch die Gasbefüllung können vorteilhafterweise bei den erfmdungsgemäß hergestellten Ferroelektret-Mehrschichtverbunden durch die Polung nochmals deutlich höhere Piezokonstanten erzielt werden.

Ein immenser Vorteil der bereitgestellten erfindungsgemäßen Verfahren auch in ihren verschiedenen vorstehend beschriebenen Ausgestaltungen ist, dass diese in weiten Bereichen materialunabhängig sind und hierdurch eine breite Anwendungsmöglichkeit gegeben ist.

Ein weiterer Gegenstand der vorliegenden Erfindung ist ein Ferroelektret-Mehrschichtverbund umfassend einen Schichtenstapel aus mindestens einer ersten Polymerfolie, und einer mit dieser verbundenen zweite Polymerfolie, wobei mindestens die erste Polymerfolie mindestens auf ihrer der zweiten Polymerfolie zugewandten Oberflächenseite eine Strukturierung mit Erhebungen und Vertiefungen aufweist und die erste Polymerfolie mit ihrem durch die Strukturierung ausgebildeten Höhenprofil mit der zweiten Polymerfolie so verbunden ist, dass zwischen den Polymerfolien ein oder mehrere Hohlräume ausgebildet sind und weiterhin die inneren Oberflächen der Hohlräume mit entgegengesetzten elektrischen Ladungen versehen sind.

Im Rahmen der vorliegenden Erfmdung kann zumindest ein Teil der Hohlräume in Formen ausgebildet sein, welche eine Querschnittsfläche in Richtung des Schichtverlaufs der Polymerfolien, ausgewählt aus der Gruppe bestehend aus im Wesentlichen runden, beispielsweise kreisförmigen, elliptischen oder ovalen, polygonen, beispielsweise dreieckigen, rechteckigen, trapezförmigen, rautenförmigen, fünfeckigen, sechseckigen, insbesondere wabenförmige, kreuzförmigen, sternförmigen und teilweise runden und teilweise polygonen, beispielsweise S-förmigen, Querschnittsflächen aufweisen, als auch vollständig in davon abweichenden Formen ausgebildet sein. Die geometrischen Formen können weiterhin regelmäßig und unregelmäßig ausgestaltet sein.

Unabhängig davon können die Hohlräume senkrecht zum Schichtverlauf der Polymerfolien im Folienstapel teilweise oder vollständig in Formen ausgebildet sein, welche eine Querschnittsfläche, ausgewählt aus der Gruppe bestehend aus im Wesentlichen runden, beispielsweise kreisförmigen, elliptischen oder ovalen, polygonen, beispielsweise dreieckigen, rechteckigen, trapezförmigen, rautenförmigen, fünfeckigen, sechseckigen, insbesondere wabenförmigen, kreuzförmigen, sternförmigen und teilweise runden und teilweise polygonen, beispielsweise S-förmigen, Querschnittsflächen, aufweisen, als auch vollständig in davon abweichenden Formen ausgebildet sein. Die geometrischen Formen können weiterhin regelmäßig und unregelmäßig ausgestaltet sein.

Insbesondere können die erfmdungsgemäßen Ferroelektret-Mehrschichtverbunde Hohlräume aufweisen, die teilweise oder vollständig keine rein blasen- oder kuppelförmige Gestalt insbesondere mit einer recheckigen Grundfläche haben. Die davon abweichenden erfindungsgemäß möglichen Formen der Hohlräume ermöglichen eine variable Einstellung der essentiellen Eigenschaften der entstehenden Mehrschichtverbunde, wie zum Beispiel der piezoelektrischen Konstanten oder der Elastizität und Weichheit des Mehrschichtverbunds entlang seiner Dicke und hierdurch eine vielfältige Anwendungsbreite. Durch die Auswahl, insbesondere der erfindungsgemäß möglichen Formen und Dimensionierung, der Hohlräume sowie deren Verteilung kann vorteilhafterweise das Gesamthohlraumvolumen des Ferroelektret-Mehrschichtverbunds optimiert werden.

Der erfindungsgemäße Mehrschichtverbund kann beispielsweise auch mehr als zwei Polymerfolien und entsprechend auch mehrere Lagen an Hohlräumen enthalten die gleiche oder unterschiedliche Form, Dimensionierung, Anzahl und Verteilungen der Hohlräume aufweisen können. Weiterhin kann der erfindungsgemäße Mehrschichtverbund mit Elektroden versehen werden. Hinsichtlich weiterer Merkmale eines erfmdungsgemäßen Ferroelektret-Mehrschichtverbunds wird hiermit explizit auf die Erläuterungen im Zusammenhang mit dem erfmdungsgemäßen Verfahren verwiesen.

Die Erfmdung betrifft weiterhin einen Ferroelektret- Zwei- oder Mehrschichtverbund mit Hohlräumen hergestellt nach einem erfmdungsgemäßen Verfahren gemäß der vorstehenden Beschreibung. Hierbei können die verschiedenen bereitgestellten Varianten des Herstellungsverfahrens und den daraus resultierenden Ferroelektret-Mehrschichtverbunden auch gegebenenfalls in Kombination miteinander durchgeführt werden. Solche erfindungsgemäßen Zwei- und Mehrschichtverbunde weisen stapelförmig geschichtete Polymerfolien und mindestens zwischen jeweils zwei Polymerfolien ausgebildete Hohlräume auf. Die Polymerfolie sind dabei zwischen den Hohlräumen miteinander verbunden. Vorteilhafterweise können die Form und Dimensionierung der Hohlräume erfmdungsgemäß sehr genau vorbestimmt und definiert hergestellt werden.

Die Erfmdung betrifft weiterhin ein piezoelektrisches Element enthaltend mindestens einen erfindungsgemäßen Ferroelektret-Mehrschichtverbund und/oder mindestens einen Ferroelektret Mehrschichtverbund hergestellt nach dem erfmdungsgemäßen Verfahren. Dieses piezoelektrische Element kann beispielsweise ein Sensor-, Aktor oder Generatorelement sein. Vorteilhafterweise kann die Erfindung in einer Vielzahl von verschiedensten Anwendungen im elektromechanischen und elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie verwirklicht werden. Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden.

Zusätzlich umfasst die Erfindung weiterhin eine Vorrichtung zur Herstellung von erfindungsgemäßen Ferroelektret-Mehrschichtverbunden. Mit anderen Worten betrifft die Erfmdung weiterhin eine Vorrichtung zur Durchführung des erfmdungsgemäßen Verfahrens, wobei die Vorrichtung Mittel zur Strukturierung mindestens einer Oberfläche einer ersten Polymerfolie umfasst. Diese Mittel können zum Beispiel eine Prägewalze, ein Prägestempel oder eine Einrichtung zur Verformung mittels Druckbeaufschlagung sein.

Zusammenfassend werden erfmdungsgemäß Verfahren zur Herstellung von Ferroelektret-Mehrschichtverbunden mit Hohlräumen bereitgestellt, die einfach und kostengünstig auch im großtechnischen Maßstab durchgeführt werden können. Die mit den erfmdungsgemäßen Verfahren erzeugten Ferroelektret-Mehrschichtaufbauten können auch mit einer größeren Anzahl von Schichten mit genau definierter Hohlraumstruktur hergestellt werden. Durch die variable Einstellbarkeit der Querschnittgeometrie und der Dimensionierung, der Form und Größe der Hohlräume, der Schichtenabfolge und Lagenanzahl sowie durch die große Materialauswahl für die eingesetzten Polymerfolien können die erfindungsgemäß erzeugten Ferroelektrete besonders gut auf entsprechende Anwendungsgebiete eingestellt werden.

Die nachfolgend beschriebenen Figuren sollen die Erfmdung im Detail weiter erläutern, ohne auf die gezeigten und beschriebenen Ausführungsformen beschränkt zu sein.

Es zeigen

Fig. 1 schematisch die Strukturierung einer ersten Polymerfolie mit einer rillenförmigen Struktur auf einer Oberfläche mittels einer Prägewalze.

Fig. 2 eine erste Polymerfolie mit einer beidseitig eingebrachten rillenförmigen Strukturierung.

Fig. 3a in einer schrägen Draufsicht schematisch die Herstellung eines Polymerfolienverbunds aus einer strukturierten Folie mit einer zweiten glatten Folie.

Fig. 3b in einer schrägen Draufsicht schematisch die Herstellung eines Polymerfolienverbunds aus einer zweiseitig strukturierten Folie mit zwei nicht strukturierten Folien.

Fig. 3c in einer schrägen Draufsicht schematisch die Herstellung eines Polymerfolienverbunds aus einer ersten strukturierten Folie mit einer zweiten gleichermaßen strukturierten Folie.

Fig. 3d in einer schrägen Draufsicht schematisch die Herstellung eines Polymerfolienverbunds aus zwei einseitig strukturierten Folie mit einer dritten nicht strukturierten Folie.

Fig. 4a bis 4g verschiedene Formen eines durch Strukturierung ausgebildeten Höhenprofils in einer Polymerfolie

Fig. 5 eine vergrößerte mikroskopische Aufnahme eines erfmdungsgemäßen Ferroelektret-Mehrschichtverbunds aus zwei Polycarbonatfolien.

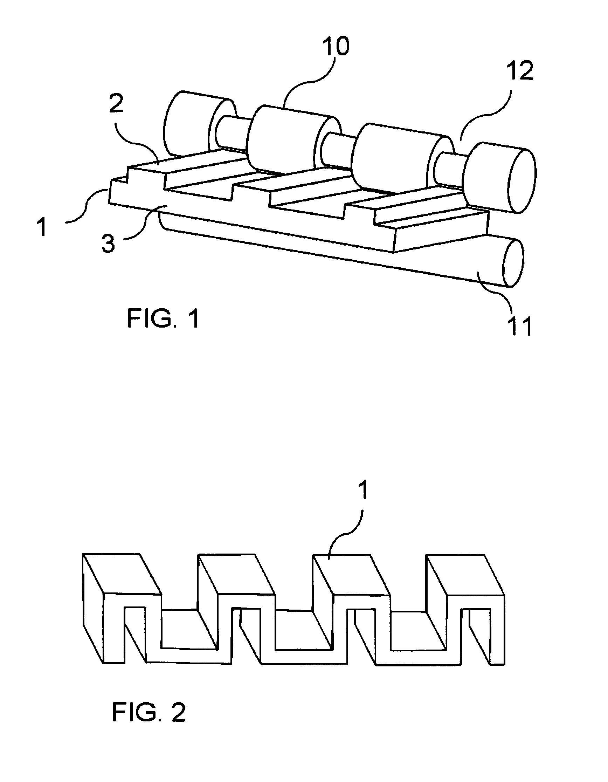

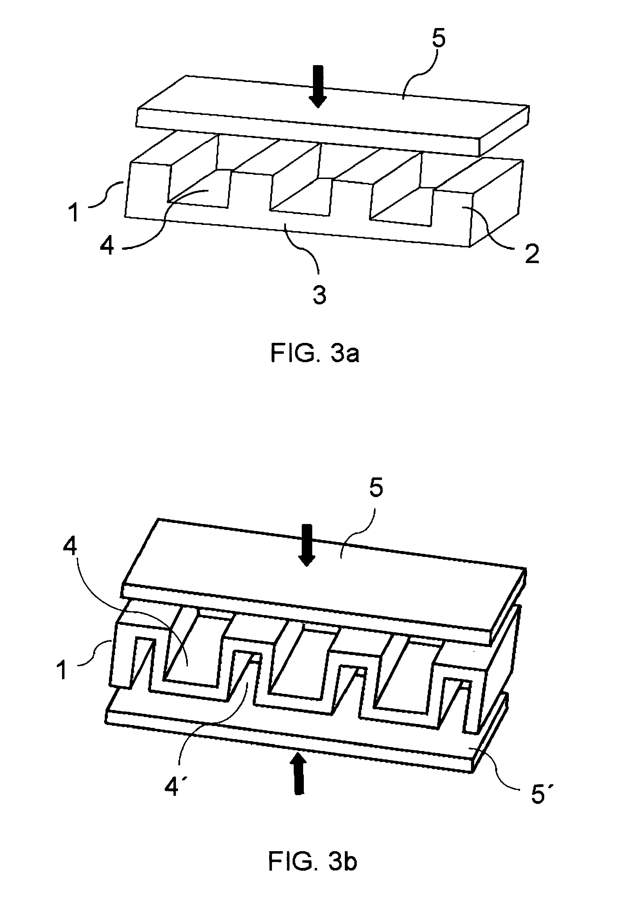

Die Figur 1 zeigt schematisch die Strukturierung einer ersten Polymerfolie 1 mit einer rillenförmigen Struktur auf einer Oberfläche mittels einer Prägewalze 10. Unter Prägewalze 10 wird eine Walze verstanden, die als Prägewerkzeug ihre Struktur auf eine Polymerfolie übertragen kann. Die Polymerfolie 1 kann beispielsweise direkt nach der Extrusion zwischen der Prägewalze 10 und einer unstrukturierten Führungswalze 11 hindurchgeführt werden. Alternativ könnte in der verwendeten Vorrichtung als Gegenstück für die Prägewalze 10 statt der Führungswalze 11 auch eine unstrukturierte Platte verwendet werden. Durch die Ausnehmungen 12 auf der Prägewalze 10 kann das entsprechende Höhenprofil auf der Polymerfolie 1 ausgebildet werden. Durch die Ausnehmungen kann eine kanalartige Strukturierung auf der Polymerfolie ausgebildet werden, wobei das Höhenprofil durch parallel angeordnete voneinander beabstandete Stege 2 auf einer geraden Grundfläche 3 ausgebildet werden kann. Die gezeigte Form der Strukturierung könnte nach einer erfindungsgemäßen Variante auch durch Schlitzdüsenextrusion mit einer entsprechend geformten Düse erhalten werden. Die eingesetzte Prägewalze kann vorteilhafterweise auch andere Prägestrukturen aufweisen, die entsprechend auf die gewünschte Form der auszubildenden Hohlräume abgestimmt werden kann. Die Grundfläche 3 der Polymerfolie 1 bildet in dieser Ausgestaltung auf ihrer, dem Höhenprofil gegenüberliegenden, Oberfläche, die unstrukturierte zweite Oberfläche der Polymerfolie 1 aus. Die Stege 2 sind in der gezeigten Ausführung mit senkrechten Seiten und geraden Kanten ausgestaltet. Wird eine solche strukturierte Polymerfolie 1 erfindungsgemäß beispielsweise mit einer nicht strukturierten Polymerfolie 5 verbunden, können kanalartige Hohlräume 4 mit einem rechteckigen Querschnitt gebildet werden wie in Figur 3a dargestellt. Die rillenförmige Struktur ist nicht auf die gezeigte Ausführungsform beschränkt und die Vertiefungen können zum Beispiel auch mit einem halbrunden Querschnitt gebildet werden. Grundsätzlich ist erfmdungsgemäß vorgesehen, dass die nach außen gerichteten Oberflächen des letztendlich gebildeten Polymerfolienverbunds nicht strukturiert sind. Auf diese nicht strukturierten Oberflächen können dann vor und/oder nach der Polung Elektroden aufgebracht werden.

Die Figur 2 zeigt eine erste Polymerfolie 1 mit einer beidseitig ausgebildeten rillenförmigen dreidimensionalen Struktur, die beispielsweise durch zwei übereinander angeordnete Prägewalzen 10 (hier nicht dargestellt) in die dazwischen hindurch geführte Polymerfolie 1 eingebracht werden kann. Die Prägewalzen 10 könnten dabei jeweils mit einer zylinderartig ausgestalteten Struktur ineinandergreifend angeordnet werden. Alternativ kann eine solchermaßen beidseitig strukturierte Polymerfolie 1 beispielsweise auch durch Verformung einer gegebenenfalls erwärmten Polymerfolie unter Druckbeaufschlagung in einem Formwerkzeug mit einem gegebenenfalls vortemperierten Kontureinsatz erfolgen. In dieser Ausführung der Polymerfolie 1 setzt das Höhenprofil nicht wie in Figur 1 dargestellt auf einer Grundfläche 3 der Polymerfolie 1 auf, sondern die Polymerfolie 1 wird insgesamt dreidimensional verformt. Nachfolgend können durch beidseitige Verbindung der ersten Polymerfolie 1 mit jeweils einer nicht strukturierten Folie zu beiden Oberflächenseiten der Polymerfolie 1 Hohlräume 4 ausgebildet werden, wie in Figur 3b dargestellt. Erfindungsgemäß ist es auch möglich, die beidseitige Strukturierung der Polymerfolie 1 derart zu gestalten, dass das Höhenprofil auf beiden Oberflächen ausgehend von einer Grundfläche 3 ausgebildet wird.

Die Figur 3a zeigt schematisch die Herstellung eines erfindungsgemäßen Polymerfolienverbunds aus einer analog zu der in Fig. 1 hergestellten strukturierten Polymerfolie 1 mit einer zweiten nicht strukturierten Polymerfolie 5. Die zweite Polymerfolie 5 kann auf der Oberfläche der Polymerfolie 1 angeordnet werden, auf der das Höhenprofil, beispielsweise in Form von Stegen 2, ausgebildet ist. Die daraus gebildeten Hohlräume 4 können in der dargestellten Ausführungsform einen rechteckigen Querschnitt aufweisen. Die Verbindung der beiden Polymerfolien 1 und 5 kann dabei durch Laminieren, Kleben, Klammern, Klemmen, Schrauben oder Nieten erfolgen.

Die Figur 3b zeigt schematisch die Herstellung eines erfmdungsgemäßen Polymerfolienverbunds aus der in Fig. 2 dargestellten beidseitig strukturierten Polymerfolie 1 mit zwei nicht strukturierten Polymerfolien 5 und 5'. Die nicht strukturierten Polymerfolien 5 und 5' können jeweils in Pfeilrichtung auf einer Oberflächenseite mit der strukturierten Polymerfolie 1 verbunden werden und jeweils durch die Verbindung eine Lage Hohlräume 4 und 4' ausbilden. Die Hohlräume 4 und 4' können in der gezeigten Ausführungsform jeweils einen rechteckigen Querschnitt aufweisen. Die Hohlräume 4 und 4' können erfindungsgemäß grundsätzlich jeweils unabhängig voneinander in variablen Formen und Größen ausgestaltet werden. Dies gilt auch für die Hohlräume 4 oder 4' in einer Lage des entstehenden Polymerfolienverbunds. Als eine Lage von Hohlräumen werden erfmdungsgemäß solche verstanden und bezeichnet, die zwischen zwei gleichen Polymerfolien ausgebildet werden. Die Hohlräume innerhalb des gebildeten Polymerfolienverbunds können den herzustellenden Ferroelektret-Mehrschichtverbund vorteilhafterweise entlang seiner Dicke, also senkrecht zum Schichtverlauf der Polymerfolien 1, 5, 5' weicher machen, damit dessen Elastizitätsmodul erniedrigen, und einen Polungsprozess in den resultierenden Hohlräumen ermöglichen. Die Verbindung der beiden Polymerfolien 1 und 5 kann dabei durch Laminieren, Kleben, Klammern, Klemmen, Schrauben oder Nieten erfolgen. Die Polung kann grundsätzlich nach der Verbindung der Polymerfolien, beispielsweise durch eine direkte Aufladung durch Anlegung einer elektrischen Spannung an schon aufgebrachte Elektroden erfolgen. Vor der Aufbringung von Elektroden kann eine Polung der sich gegenüberliegenden Seiten der Hohlräume beispielsweise durch eine Corona-Entladung oder ein Plasma-Verfahren realisiert werden.

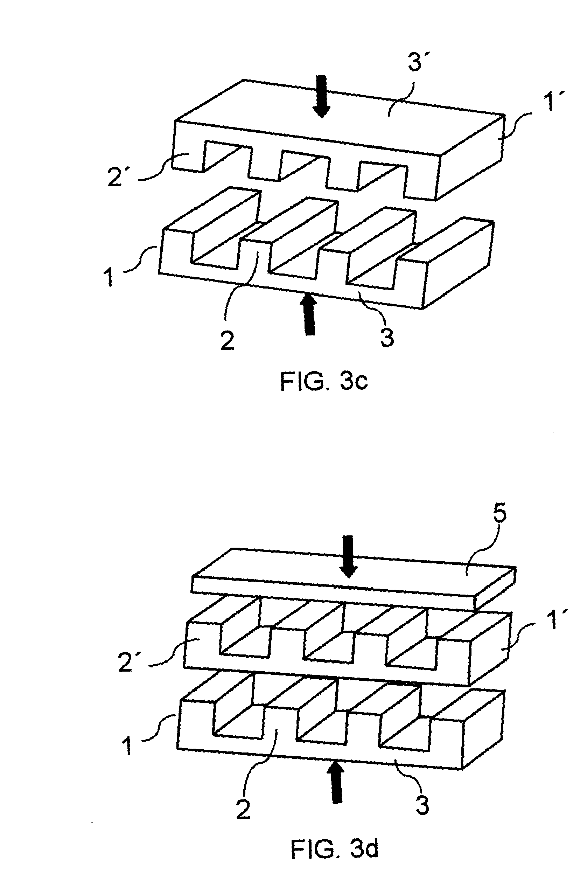

Die Figur 3c zeigt schematisch die Herstellung eines erfindungsgemäßen Polymerfolienverbunds aus einer analog zu der in Fig. 1 hergestellten strukturierten Polymerfolie 1 mit einer zweiten gleichartig strukturierten Polymerfolie 1'. Beide Polymerfolien 1 und 1' weisen als Höhenprofil Stege 2 auf einer Grundfläche 3 auf. Die Polymerfolien 1 und 1' können jeweils mit ihren strukturierten Oberflächenseiten mit den ausgebildeten Stegen verbunden werden. Die Stege 2 können dabei in Pfeilrichtung passgenau aufeinander gesetzt werden, wobei kanalartige Hohlräume 4 mit einem rechteckigen Querschnitt senkrecht zum Schichtverlauf der Polymerfolien 1 und 1' entstehen können. Die Verbindung der beiden Polymerfolien 1 und 1' kann dabei durch Laminieren, Kleben, Klammern, Klemmen, Schrauben oder Nieten erfolgen.

Die Figur 3d zeigt schematisch die Herstellung eines erfmdungsgemäßen Polymerfolienverbunds aus einer analog zu der in Fig. 1 hergestellten strukturierten Polymerfolie 1 mit einer zweiten gleichartig strukturierten Polymerfolie 1' und einer weiteren nicht strukturierten Polymerfolie 5. Erfindungsgemäß ist es wie dargestellt möglich, die zweite strukturierte Polymerfolie 1' mit ihrer nicht strukturierten Oberfläche in Pfeilrichtung auf der strukturierten Oberflächenseite der Polymerfolie 1 anzuordnen und mit dieser zu verbinden. Durch Verbinden der Polymerfolie 1' mit einer weiteren Polymerfolie 5 kann dann eine zweite Lage von Hohlräumen ausgebildet werden. In der gezeigten Ausführungsform werden die strukturierten Folien 1 und 1' mit der gleichen Ausrichtung der Struktur aufeinander angeordnet und nachfolgend miteinander verbunden. Gleichermaßen können die Strukturen auch unterschiedlich ausgerichtet werden. Zum Beispiel könnten die Strukturen- in diesem Fall die Stege mit einem Winkel von 45° oder von 90° zueinander angeordnet werden, wobei erfindungsgemäß alle Anordnungen in unterschiedlichen Winkeln bzw. Ausrichtungen der Strukturen zueinander möglich sind. Die Schichtabfolge der Polymerfolien 1 und 1' kann variabel mit einer oder mehreren strukturierten und/oder nicht strukturierten Polymerfolien fortgesetzt und variabel gestaltet werden. Vorteilhafterweise ist die Herstellung eines Ferroelektret-Mehrschichtverbunds mit mehreren Lagen mit Hohlräumen somit auf unterschiedliche Art und Weise möglich und kann gegebenenfalls auf vorhandene Polymerfolien als Vorprodukte oder auf eine geplante Anwendung und gewünschte Eigenschaften, wie zum Beispiel Elastizitätsmodul und Piezoelektrische Konstanten, angepasst werden.

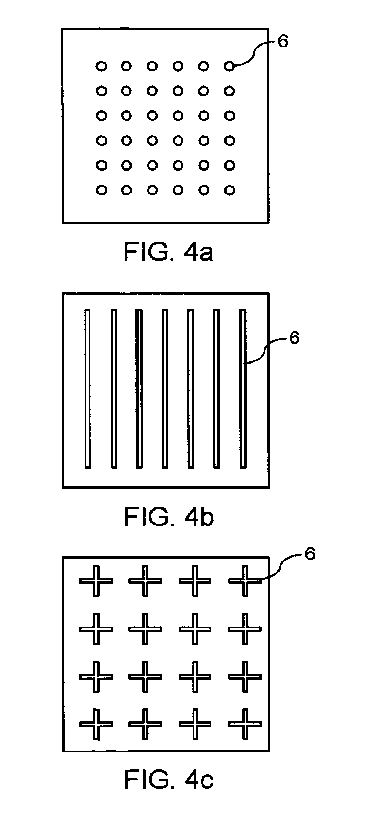

Die Fig. 4a-4g zeigen schematische Draufsichten auf verschiedene Ausführungsformen von Prägestrukturen in Polymerfolien 1 und damit die mögliche Ausgestaltung der Grundflächen der entsprechenden Hohlräume quer zum Schichtverlauf der Polymerfolien 1. Die Strukturen können beispielsweise durch Prägung grundsätzlich als Positiv- oder Negativformen, also als Vertiefungen oder Erhebungen in eine Polymerfolie 1 eingebracht werden. Die gezeigten Ausführungsformen und Ausgestaltungen der Strukturierung stellen nur Beispiele dar und sollen die Erfmdung nicht in irgendeiner Form einschränken. Aus Gründen der Übersichtlichkeit ist in den Figuren 4a bis 4g jeweils nur eine Aussparung einer Form beispielhaft mit einem Bezugszeichen gekennzeichnet.

Figur 4a zeigt eine, Vertiefungen 6 umfassende, strukturierte Polymerfolie 1, wobei die Vertiefungen eine kreisförmige Grundfläche aufweisen. Die Vertiefungen 6 können, wie in Figur 4a veranschaulicht, darüber hinaus, als eine Vielzahl von kleinen Vertiefungen 6 ausgebildet werden.

Figur 4b zeigt eine, Vertiefungen 6 umfassende strukturierte Polymerfolie 1, wobei die Vertiefungen 6 eine längliche, rechteckige Grundfläche aufweisen.

Figur 4c zeigt eine, Vertiefungen 6 umfassende strukturierte Polymerfolie 1, deren Vertiefungen 6 eine kreuzförmige Grundfläche aufweisen.

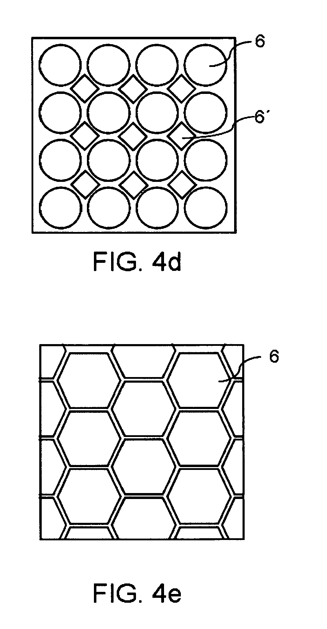

Figur 4d zeigt eine, verschiedene Vertiefungen 6, 6' umfassende strukturierte Polymerfolie, deren Vertiefungen teilweise eine kreisförmige Grundfläche 6 und teilweise eine rautenförmige Grundfläche 6' aufweisen. Figur 4d veranschaulicht, dass bei einer homogen verteilten Anordnung von Vertiefungen mit kreisförmigen 6 und rautenförmigen 6' Querschnittsflächen vorteilhaft ein besonders großes Gesamthohlraumvolumen erzielt werden kann.

Figur 4e zeigt eine Vertiefungen 6 umfassende Polymerfolie 1, deren Vertiefungen 6 eine wabenförmige Grundfläche aufweisen. Figur 4e veranschaulicht, dass durch eine Anordnung, welche ausschließlich auf Vertiefungen 6 mit wabenförmigen Querschnittsflächen basiert, ebenfalls ein vorteilhaft großes Gesamthohlraumvolumen erzielt werden kann.

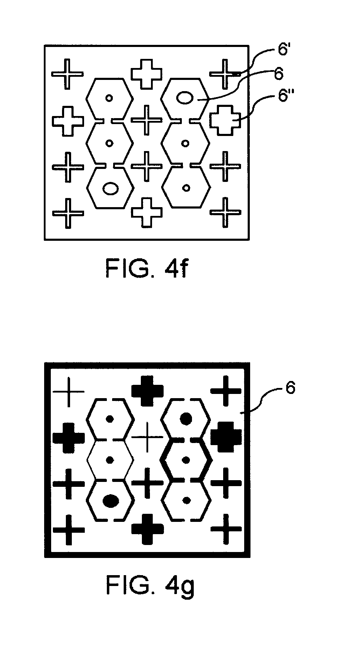

Figur 4f zeigt eine, Vertiefungen 6, 6', 6" umfassende strukturierte Polymerfolie 1, deren Struktur in unterschiedlicher Form und Größe ausgebildet sind und die kreuzförmige 6', 6" und im Wesentlichen wabenförmige Flächen 6 aufweisen. Figur 4f zeigt weiterhin, dass die Vertiefungen 6, 6', 6" unhomogen verteilt und teilweise miteinander verbunden ausgebildet sein können.

Figur 4g zeigt eine Vertiefungen 6 umfassende Polymerfolie 1, deren Vertiefungen 6 durch Aufbringen einer Kombination unterschiedlicher Strukturen, insbesondere von Sechsecken/Waben, Kreuzen und Punkten unterschiedlicher Punkt- und Linienstärke, ausgebildet sind. Figur 4g zeigt weiterhin, dass zumindest die Randbereiche der durchgehenden Polymerschicht mit einer geschlossenen Struktur ausgebildet sein können, um nach Abschluss des erfindungsgemäßen Herstellungsverfahrens einen oder mehr abgeschlossene, mit den durchgehenden Polymerschichten in Kontakt stehende Hohlräume zu erhalten. Auf diese Weise kann ein zusammenhängender Hohlraum ausgebildet werden. Figur 4g veranschaulicht weiterhin, dass im Rahmen der vorliegenden Erfmdung unter einer strukturierten Polymerfolie 1 mit Höhenprofil auch eine Polymerfolie verstanden werden kann, welche nur eine Vertiefung 6 aufweist, wobei diese auch als Zusammenschluss beziehungsweise Verbindung von mehreren Vertiefungen verstanden werden kann.

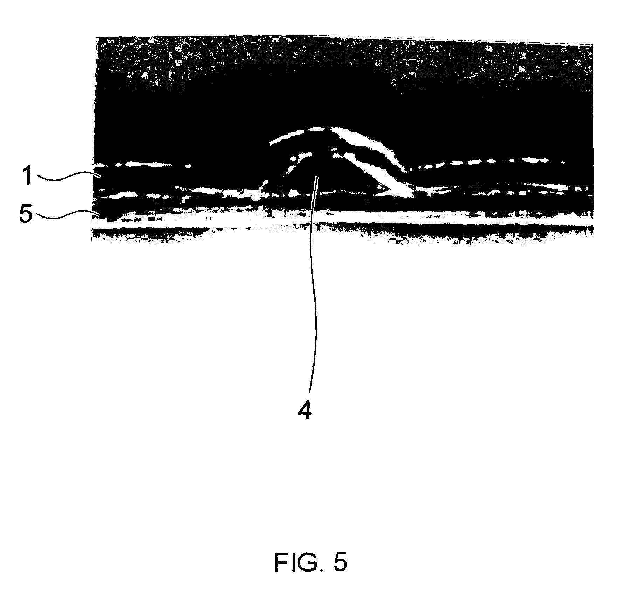

Fig. 5 zeigt eine vergrößerte mikroskopische Aufnahme eines erfindungsgemäßen Ferroelektret-Mehrschichtverbunds aus zwei Polycarbonatfolien im Querschnitt. Die strukturierte Polymerfolie 1, eine Polycarbonatfolie (Makrofol Bayer MaterialScience AG) mit einer Dicke von 75 μm, wurde hierfür knapp unter die Glastemperatur auf 130-140°C erwärmt. Danach wurde die Polycarbonatfolie 1 mit einem Luftdruck von 250 bar auf das Formwerkzeug mit einem Rillenprofil gepresst. Durch das Formwerkzeug wurde die Polycarbonatfolie 1 derart verformt, dass sich halbzylinderförmige Vertiefungen ausbildeten. Auf der gegenüberliegenden Oberfläche der Polymerfolie 1 wurde in diesem Fall die Struktur entsprechend als halbzylinder-förmiges Höhenprofil ausgebildet. Auf die strukturierte Polycarbonatfolie 1 wurde auf der Oberflächenseite, die als Struktur die Vertiefungen aufwies, eine glatte Polycarbonatfolie 5 mit 75 μm Dicke aufgelegt und mit der ersten durch Laminieren verbunden. Hierdurch ergaben sich Hohlräume 4 mit einem halbkreisförmigen Querschnitt senkrecht zum Schichtverlauf der Polymerfolien 1 und 5. Die Hohlräume 4 hatten im Querschnitt eine Höhe von 100 μm. Die kompakte, die Erhebung aufweisende äußere Oberfläche der Polymerfolie 1, sowie die nach außen gerichtete nichtstrukturierte Oberfläche der Polymerfolie 5 wurde nachfolgend jeweils mit einer Aluminiumelektrode von 50 nm Dicke versehen. Die Polung der inneren Hohlräume 4 erfolgte durch direkt angelegte elektrische Spannung. Der erzeugte Verbund zeigte eine gute Piezoaktivität, die der Piezoaktivität der gemäß Beispiel 5 erhaltenen Proben vergleichbar war.

Durch die nachfolgend aufgeführten Beispiele soll die Erfindung weiter erläutert werden, ohne auf diese beschränkt zu sein.

Beispiele

Beispiel 1:

Herstellung eines Gleitmittel-Additiv-Masterbatches

Herstellung des Gleitmittel-Additiv-Compounds mit herkömmlichen Zweischnecken Compoundierextrudern (z.B. ZSK 32) bei für Polycarbonat üblichen Verarbeitungstemperaturen von 250 bis 330°C.

Es wurde ein Master-Batch mit folgender Zusammensetzung hergestellt:

• Polycarbonat Makrolon 2600 000000 der Fa. Bayer MaterialScience AG mit einem Anteil von 98 Gew.-%

• Di-isopropyl-dimethylammonium-perfluorbutansulfonat als farbloses Pulver mit einem Anteil von 2 Gew.-%.

Beispiel 2:

Folien-Extrusion:

Es wurde ein Compound folgender Zusammensetzung abgemischt:

• Gleitmittel-Additiv-Masterbatch gemäß Beispiel 1 mit einem Anteil von 20 Gew.% und Polycarbonat Makrolon 2600 der Fa. Bayer MaterialScience AG mit einem Anteil von 80,0 Gew.-%

Die verwendete Anlage für die Herstellung der Folien besteht aus

- einem Hauptextruder mit einer Schnecke von 105 mm Durchmesser (D) und einer Länge von 41xD; die Schnecke weist eine Entgasungszone auf;

- einer Extrusions-Breitschlitzdüse mit 1500 mm Breite;

- einem Dreiwalzen-Glättkalander mit horizontaler Walzenanordnung, wobei die dritte Walze um +/- 45° gegenüber der Horizontalen schwenkbar ist;

- einer Rollenbahn;

- einer Einrichtung zum beidseitigen Aufbringen von Schutzfolien;

- einer Abzugseinrichtung;

- Aufwickelstation.

Das Granulat wurde dem Fülltrichter des Extruders zugeführt. Im Plastifiziersystem Zylinder/Schnecke des Extruders erfolgte das Aufschmelzen und Fördern des Materials. Die Materialschmelze wurde dem Glättkalander zugeführt, dessen Walzen die in der Tabelle 1 genannte Temperatur aufwiesen. Auf dem Glättkalander (bestehend aus drei Walzen) erfolgte die endgültige Formgebung und Abkühlung der Folie.

Tabelle 1

| Verfahrensparameter | |
|---|---|
| Temperatur des Hauptextruders | 275°C +/- 5°C |
| Temperatur des Coextruders | 260°C +/- 5°C |
| Temperatur des Umlenkkopfes | 285°C +/- 5°C |
| Temperatur der Düse | 300°C +/- 5°C |
| Drehzahl des Hauptextruders | 45 min$^{-1}$ |
| Drehzahl des Coextruders | 12 min$^{-1}$ |
| Temperatur der Gummiwalze 1 | 24°C |
| Temperatur der Walze 2 | 72°C |
| Temperatur der Walze 3 | 131°C |
| Abzugsgeschwindigkeit | 21,5 m/min |

Zur einseitigen Strukturierung der Folienoberfläche wurde dabei eine Gummi-Walze auf einer ersten Position in der verwendeten Anlage eingesetzt. Die für die Strukturierung der Folienoberfläche verwendete Gummi-Walze ist in der Patentschrift US 4,368,240 der Fa. Nauta Roll Corporation offenbart.

Auf einer zweiten Position in der Anlage wurde eine mit einer Advanced Compound Parabolic Concentrator (ACPC) Struktur strukturierte Metallwalze eingesetzt. Die ACPC Struktur wurde mit folgenden Parametern: Akzeptanzwinkel: 8°, Verkürzungsfaktor: 0.05 eingesetzt.

Der Compound Parabolic Concentrator (CPC) -Bereich der Struktur konnte bestimmt werden durch:

a) Berechnen der Öffnungswinkel im Medium $\theta_1$ und $\theta_2$ aus den Fresnelschen Gleichungen mittels der definierten Akzeptanzwinkel;

b) Konstruktion der beiden Parabeläste $P_1$ und $P_2$ mit den Öffnungswinkeln im Medium $\theta_1$ bzw. $\theta_2$ gemäß der Gleichung:

$$y_{1,2} = \frac{\left(x \mp \cos\theta_{1,2}\right)^2}{2\left(1 \mp \sin\theta_{1,2}\right)} - \frac{1 \pm \sin\theta_{1,2}}{2}$$

wobei $\theta_{12}$ der Öffnungswinkel im Medium der linken ($\theta_1$) und rechten ($\theta_2$) Parabel, x die X-Koordinate, und $y_{1,2}$ die die Y-Koordinate der linken ($y_1$) und rechten ($y_2$) Parabel ist;

c) Berechnung der Endpunkte der Parabeläste $F_1$, $F_2$ und $E_1$ $E_2$;

d) Drehung der Parabeln um den Öffnungwinkel im Medium -$\theta_1$ bzw. $\theta_2$ und Translation der Parabel $P_2$ längs der x-Achse;

e) optional im Falle einer asymmetrischen Variante mit $\theta_1 \neq \theta_2$ der Bestimmung der Neigung der durch die Punkte $E_1$ und $E_2$ bestimmten Neigungsfläche;

f) Bestimmung der effektiven Akzeptanzwinkel in Luft aus der in den Schritten a) bis e) konstruierten Geometrie;

g) Vergleich der effektiven Akzeptanzwinkel mit den definierten Akzeptanzwinkeln, und bei Abweichung größer 0,001% Wiederholung von Schritt a) bis f) mit korrigierten Akzeptanzwinkeln anstelle der definierten Akzeptanzwinkel in Schritt a), wobei die korrigierten Akzeptanzwinkeln ungleich sind den definierten Akzeptanzwinkeln, und wobei die korrigierten Akzeptanzwinkel so gewählt werden, dass die effektiven Akzeptanzwinkel aus Schritt f) mit den definierten Akzeptanzwinkeln übereinstimmen; und

h) beim Erreichen einer Abweichung der effektiven Akzeptanzwinkel von den definierten Akzeptanzwinkeln von 0,001% oder weniger Verkürzung der Parabeln in y-Richtung auf das durch den Verkürzungsfaktor bestimmte Maß.

Die vorstehend angeführte Konstruktionsbeschreibung ist so allgemein gehalten, dass die ACPC-Struktur tragende Walze grundsätzlich auch aus verschiedenen Werkstoffen (Medium 1: zum Beispiel PMMA oder Polycarbonat) hergestellt sein kann. Darüber hinaus kann der ACPC Bereich in verschiedener Umgebung (Medium 2: z.B. Luft oder Wasser) eingesetzt werden. Das heißt Medium 1 und Medium 2 gehen dann mit ihren Brechungsindices in die genannten Fresnelschen-Gleichungen ein.

Anschließend wurde die geprägte Folie durch einen Abzug transportiert. Danach konnte eine Schutzfolie aus Polyethylen beidseitig aufgebracht werden und eine Aufwicklung der Folie erfolgen. Es wurde eine Folie mit 180 $\mu$m Dicke der Grundschicht erhalten, bei der auf der einen Seite die ACPC-Struktur aufgeprägt wurde und auf der anderen Seite eine Texturierung mit einer Rautiefe $R_3z$ von 8$\mu$m. Die Höhe der ACPC-Struktur ausgehend von der Grundschicht war 73 $\mu$m und der Abstand 135 $\mu$m. Mit anderen Worten ergibt sich ein Abstand von Tal zu Tal von 135 $\mu$m und in der Lotrechten ein Abstand von Tal zu Scheitelpunkt des Bergs von 73 $\mu$m.

Beispiel 3:

Herstellung eines Ferroelektret-Mehrschichtverbunds aus einer ersten Folie mittels Walze strukturierten Folie und einer glatten Polycarbonatfolie mit 20 $\mu$m Dicke":

Eine glatte 20 $\mu$m dicke Polycarbonatfolie wurde auf die strukturierte Seite einer mit dem ACPC Walzenprofil, wie es in Beispiel 1 beschrieben wurde, versehenen Polycarbonatfolie mit einer Dicke von 285 $\mu$m gelegt. Dieser Folienverbund wurde dann bei 205 °C laminiert. Nach dem Laminieren weist der Folienverbund eine Schichtdicke von 285 $\mu$m auf. Dem Tiefenprofil der Folie mit Walzenprofil folgend bilden sich im Polymerfolienverbund der zwei Polycarbonatfolien Hohlräume aus. Diese Hohlräume haben im Querschnitt eine Höhe von 40 $\mu$m und eine Breite von 25 $\mu$m. Der Abstand der Hohlräume wird durch das eingeprägte Walzenprofil vorgegeben. Bei dem Laminierprozess wird das Walzenprofil allerdings etwas abgeflacht, sodass die Hohlräume kleiner ausfallen als die Höhe des ursprünglichen Walzenprofils vorgibt. Dadurch wird die Gesamtdicke des Schichtstapels kleiner als die Summe der Schichtdicken der Einzelfolien vor dem Laminierprozess. Der Folienverbund wurde nachfolgend auf beiden Oberflächen mit Aluminiumelektroden von 50 nm Dicke versehen. Die Polung der inneren Hohlräume erfolgte durch direkt angelegte elektrische Spannung von 17 bis 19 kV. Der Piezoelektrische Effekt wurde direkt nach der Polung gemessen.

Die Messungen ergaben für die Polung mit 17 kV einen d33 Koeffizienten von 4 pC/N direkt nach der Polung und für die Polung mit 19 kV ergab sich ein d33 Koeffizient von 5 pC/N. Es wurden zu jeder Probe fünf Messungen durchgeführt und der Mittelwert gebildet.

Beispiel 4:

Herstellung eines Ferroelektret-Mehrschichtverbunds aus einer Polycarbonatfolie mit Walzenprofil und einer glatten Polycarbonatfolie mit 50 $\mu$m Dicke:

Eine glatte 50 $\mu$m dicke Polycarbonatfolie wurde auf die profilierte Seite einer analog zu Beispiel 1 mit dem Walzenprofil versehenen Folie mit einer Gesamtdicke von 285 $\mu$m gelegt. Dieser Folienverbund wurde dann bei 205°C laminiert. Nach dem Laminieren weist der Folienverbund eine Dicke von 320 $\mu$m auf. Dem Tiefenprofil der Folie mit Walzenprofil folgend bilden sich im Polymerfolienstapel dreieckförmige Hohlräume aus. Diese Hohlräume haben eine Tiefe von ca. 40 $\mu$m und eine Breite von 60 $\mu$m. Der Abstand der Hohlräume wird durch das eingeprägte Walzenprofil vorgegeben. Bei dem Laminierprozess wird die 50 $\mu$m dicke Polycarbonatschicht in das Walzenprofil hineingedrückt, so dass die Hohlräume kleiner ausfallen als die Höhe des ursprünglichen Walzenprofils vorgibt. Dadurch ist die Gesamtdicke des Polymerfolienverbunds kleiner als die Summe der Schichtdicken der Einzelfolien vor dem Laminierprozess. Der Folienverbund wurde nachfolgend auf beiden Oberflächen mit Aluminiumelektroden von 50 nm Dicken versehen. Die Polung der inneren Hohlräume erfolgte durch direkt angelegte elektrische Spannung von 20 kV. Der Piezoelektrische Effekt wurde direkt nach der Polung gemessen. Gemäß diesem Beispiel wurden vier Proben mit 4 cm x 4 cm hergestellt, jeweils fünfmal vermessen.

Für die Messungen direkt nach der Polung ergaben sich die in der Tabelle 2 dargestellten Mittelwerte.

Tabelle 2

| Probe | 1 | 2 | 3 | 4 |
|---|---|---|---|---|
| d33 | 6 pC/N | 3 pC/N | 8 pC/N | 6 pC/N |

Beispiel 5:

Herstellung eines Ferroelektret-Mehrschichtverbunds aus zwei mittels Prägewalze strukturierten Polycarbontatfolien:

Die profilierten Seiten zweier mit dem Walzenprofil versehenen Folien jeweils mit einer Gesamtdicke (Grundfläche und Struktur) von 285 $\mu$m wurden so aufeinander gelegt, dass sich die eingeprägten Strukturen kreuzen. Dieser Folienverbund wurde dann bei 205°C laminiert. Nach dem Laminieren weist der Folienverbund eine Schichtdicke von 550 $\mu$m auf. Dem Tiefenprofil der Folien mit Walzenprofil folgend bilden sich im Schichtstapel Hohlräume aus. Die Hohlräume wurden 45° zur gekreuzten Struktur vermessen und haben im Querschnitt eine Höhe von ca. 50 $\mu$m und eine Breite von 100 $\mu$m. Der Abstand der Hohlräume bei der Vermessung unter 45° liegt bei 190 $\mu$m. Bei dem Laminierprozess wurde das Walzenprofil abgeflacht, so dass die Abmessungen der Hohlräume kleiner ausfielen als die Höhe des ursprünglichen Walzenprofils vorgab. Dadurch war die Gesamtdicke des Schichtstapels kleiner als die Summe der Schichtdicken der Einzelfolien vor dem Laminierprozess. Der Folienverbund wurde nachfolgend auf beiden, nach außen gerichteten Oberflächen mit Aluminiumelektroden von 50 nm Dicke versehen. Die Polung der inneren Hohlräume erfolgte durch direkt angelegte elektrische Spannung von 20 kV. Der Piezoelektrische Effekt wurde direkt nach der Polung gemessen. Gemäß diesem Beispiel wurden neun Proben mit 4 cm x 4 cm hergestellt und vermessen. Es wurden jeweils fünf Messungen der piezoelektrischen Konstanten durchgeführt und der Mittelwert daraus gebildet.

Für die Messungen direkt nach der Polung ergaben sich die in der Tabelle 3 dargestellten Werte.

Tabelle 3

| Probe | 1 | 2 | 3 | 4 | 5 | 6 | 7 | 8 | 9 |
|---|---|---|---|---|---|---|---|---|---|
| d33 | 4 pC/N | 4 pC/N | 12 pC/N | 22 pC/N | 4 pC/N | 10 pC/N | 6 pC/N | 14 pC/N | 3 pC/N |

Beispiel 6:

"Herstellung eines Ferroelektret-Mehrschichtverbunds aus einer ersten, mittels Druckbeaufschlagung in einem Formwerkzeug strukturierten Folie und einer glatten Polycarbonatfolie.

Eine Polycarbonatfolie (Makrofol Bayer MaterialScience AG) mit einer Dicke von 75 $\mu$m wurde knapp unter die Glastemperatur auf 130-140°C erwärmt. Danach wurde die Polycarbonatfolie mit einem Luftdruck von 250 bar auf das Formwerkzeug mit einem Rillenprofil gepresst. Die Polycarbonatfolie passte sich der Werkzeugkontur an und wurde permanent rillenförmig verformt. Die Folie wurde dabei in ihrer Gesamtheit verformt, so dass auf einer Oberfläche ein Höhenprofil und entsprechend auf der anderen Oberflächenseite der Polycarbonatfolie rillenförmige Vertiefungen entstanden. Auf diese strukturierte Polycarbonatfolie wurde eine glatte Polycarbonatfolie mit 75 $\mu$m Dicke aufgelegt und mit der ersten durch Laminieren verbunden. Es ergaben sich Hohlräume mit einem halbkreisförmigen Querschnitt, senkrecht zum Schichtverlauf der Polymerfolien. Die Hohlräume hatten im Querschnitt eine Höhe von 100 $\mu$m. Der Folienverbund wurde nachfolgend auf beiden Oberflächen mit Aluminiumelektroden von 50 nm Dicke versehen. Die Polung der inneren Hohlräume erfolgte durch direkt angelegte elektrische Spannung. Der erzeugte Verbund zeigte eine gute Piezoaktivität, die der Piezoaktivität der gemäß Beispiel 5 erhaltenen Proben vergleichbar war. Ein vergrößerter Ausschnitt des Polymerfolienverbunds im Bereich eines Hohlraums ist in Figur 5 gezeigt.

Beispiel 7:

"Ferroelektret-Mehrschichtverbund aus einer Polycarbonatfolie mit Prägestempelprofil und einer glatten Polycarbonatfolie mit 125 $\mu$m Dicke"

Ein Prägestempel aus Aluminium wurde mit einer Rillenstruktur versehen. Hierbei haben die Rillen einen Abstand von 1 mm, eine Tiefe von 80 $\mu$m. In diesen Prägestempel wurde in einer Heißpresse eine Polycarbonatfolie (Makrofol DE 1-1, 125 $\mu$m Dicke) hineingedrückt, so dass die Rillenstruktur als Höhenprofil auf der Polycarbonatfolie erhaben war. Auf eine zweite Polycarbonatfolie (Makrofol DE 1-1, 125 $\mu$m Dicke) wurde eine Apec 1800 Lösung in Mesitylen, 1 Methoxy-2-propanolacetat, 1,2,4-Trimethylbenzol, Ethyl-3-ethoxypropionat, Cumol und Solvent Naphtha aufgerakelt. Anschließend wurden die beiden Folien leicht aufeinander gedrückt, bis die Lösungsmittel verdunstet waren, und wurden auf diese Weise miteinander verbunden. Der erzeugte Verbund wurde auf den nach außen gerichteten Oberflächen mit Elektroden versehen und die inneren Hohlräume 4 gepolt. Der Polymerfolienverbund zeigte eine gute Piezoaktivität, die der Piezoaktivität der gemäß Beispiel 5 erhaltenen Proben vergleichbar war.

Versuchsaufbau für die mechanische Messung der d33 Piezokonstanten der hergestellten Ferroelektret-Mehrschichtverbund-Systeme und Durchführung der Messungen

Für die Messeinrichtung werden grundsätzlich folgende drei Hauptkomponenten benötigt: Krafterzeuger, Kraftmessgerät und Ladungsmessgerät. Als Krafterzeuger wurde ein elektrischer Schwingerreger Typ 4810 von Brüel & Kjær gewählt. Der Schwingerreger ermöglicht es, eine definierte Kraft in Abhängigkeit von der Eingangsspannung auszuüben. Dieser Schwingerreger wurde an einer beweglichen Plattform montiert, deren Position in vertikaler Richtung manuell einstellbar ist. Die Höhenverstellbarkeit des Schwingerregers ist zum Einspannen der Proben notwendig. Außerdem kann damit der statische Vordruck, der für die Messung erforderlich ist, eingestellt werden. Zur Steuerung des Schwingerregers wurde ein Funktionsgenerator DS 345 von Stanford Research Systems in Verbindung mit einem Leistungsverstärker Typ 2718 von Brüel & Kjær benutzt. Als Kraftmessgerät wurde ein Kraftsensor Typ 8435 von Burster verwendet. Der Kraftsensor ist sowohl auf Druck- als auch auf Zugmessungen im Bereich von 0 bis 200 N ausgelegt. Die Krafteinwirkung darf allerdings nur senkrecht erfolgen, so dass keine seitliche Kraftkomponente oder Drehmomente auf den Sensor einwirken. Um dies zu gewährleisten, wurde der Kraftsensor mit einer zylinderförmigen Druckführungsschiene mit einem darin beinahe reibungslos gleitenden Bolzen aus Edelstahl versehen. Am freien Ende des Bolzens befand sich eine zwei Zentimeter breite polierte Platte, die als Auflagefläche für die Proben diente. Die Signale vom Kraftsensor werden mit einem Modulverstärker Typ 9243 von Burster erfasst und weiter an ein Oszilloskop GOULD 4094 geleitet.

Als Ladungsmessgerät wurde ein Ladungsverstärker Typ 2635 von Brüel & Kjær verwendet. Der Ladungsverstärker ermöglicht es, Ladungen bis zu 0,1 pC zu erfassen. Für die Messung der Oberflächenladung müssen die beiden Seiten der Probe mit dem Ladungsverstärker elektrisch verbunden sein. Der elektrische Kontakt zu der unteren Seite der Probe wird durch die Auflagefläche ermöglicht, die ihrerseits mit dem gesamten Aufbau verbunden ist. Die obere Seite der Probe wurde durch den Druck-Ausübenden Stempel aus Messing mit dem Ladungsverstärker verbunden. Der Stempel wird durch einen Aufsatz aus Plexiglas am Schwingerreger von dem restlichen Aufbau elektrisch isoliert und durch ein Kabel mit dem Ladungsverstärker verbunden. Das Kabel sollte möglichst dünn und weich sein, um mechanische Spannungen und damit Verfälschungen der Messergebnisse zu vermeiden. Das gemessene Signal wird schließlich vom Ladungsverstärker zum Oszilloskop weitergeleitet. Standardmäßig wurde ein Vordruck von 3 N (statisch) eingestellt und mit einer Amplitude von 1 N (dynamisch) gemessen.

## Patentansprüche

1. Verfahren zur Herstellung eines Ferroelektret- Zwei- oder Mehrschichtverbunds mit Hohlräumen **gekennzeichnet durch** die folgenden Schritte:

   a) Strukturieren mindestens einer ersten Oberfläche einer ersten Polymerfolie (1) unter Ausbildung eines Höhenprofils,
   b) Auflegen mindestens einer zweiten Polymerfolie (5, 1') auf die in Schritt a) gebildete strukturierte Oberfläche der ersten Polymerfolie,
   c) Verbinden der Polymerfolien (1, 1', 5) zu einem Polymerfolienverbund unter Ausbildung von Hohlräumen (4, 4') und
   d) die elektrische Aufladung der inneren Oberflächen der in Schritt c) ausgebildeten Hohlräume (4, 4') mit entgegengesetzten elektrischen Ladungen.

2. Verfahren nach Anspruch 1 **dadurch gekennzeichnet, dass** die Strukturierung der mindestens einen Oberfläche der ersten Polymerfolie (1) in Schritt a) durch eine Prägung erfolgt.

3. Verfahren nach Anspruch 2 **dadurch gekennzeichnet, dass** die Prägung unter Verwendung einer strukturierten Walze erfolgt.

4. Verfahren nach Anspruch 2 **dadurch gekennzeichnet, dass** die Prägung unter Verwendung eines strukturierten Prägestempels erfolgt.

**5.** Verfahren nach Anspruch 1 **dadurch gekennzeichnet, dass** die Strukturierung der mindestens einen Oberfläche der ersten Polymerfolie (1) in Schritt a) durch Verformung der gegebenenfalls erwärmten Polymerfolie (1) unter Druckbeaufschlagung in einem Formwerkzeug mit einem gegebenenfalls vortemperierten Kontureinsatz erfolgt.

**6.** Verfahren nach Anspruch 1 **dadurch gekennzeichnet, dass** die Strukturierung der mindestens einen Oberfläche der ersten Polymerfolie (1) in Schritt a) durch Schlitzextrusion der Polymerfolie mit geformter Düse erfolgt.

**7.** Verfahren nach Anspruch 1 **dadurch gekennzeichnet, dass** das Verbinden der Polymerfolien zu einem Polymerfolienverbund in Schritt c) durch Laminieren, Kleben, Klammern, Klemmen, Schrauben oder Nieten erfolgt.

**8.** Verfahren nach Anspruch 1 **dadurch gekennzeichnet, dass** vor und/oder nach der elektrischen Aufladung der inneren Oberflächen der Hohlräume in Schritt d) die Aufbringung von Elektroden an den äußeren Oberflächen des Polymerfolienverbunds erfolgt.

**9.** Verfahren nach Anspruch 1 **dadurch gekennzeichnet, dass** die Schritte a), b), c) und/oder d) als kontinuierlicher Rolle-zu-Rolle Prozess durchgeführt werden.

**10.** Verfahren nach Anspruch 1 **dadurch gekennzeichnet, dass** es als weiteren Schritt e) vor oder nach der Aufladung in Schritt d) das Versiegeln der Kanten des in Schritt c) gebildeten Polymerfolienverbunds umfasst.

**11.** Verfahren nach Anspruch 1 **dadurch gekennzeichnet, dass** es als weiteren Schritt f) vor der Polung in Schritt d) das Einfüllen eines Gases in die Hohlräume im Polymerfolienverbund umfasst.

**12.** Ferroelektret Zwei- oder Mehrschichtverbund umfassend einen Schichtenstapel aus mindestens einer ersten Polymerfolie (1) und einer mit dieser verbundenen zweiten Polymerfolie (1', 5) **dadurch gekennzeichnet, dass** mindestens die erste Polymerfolie (1) mindestens auf ihrer der zweiten Polymerfolie (1', 5) zugewandten Oberflächenseite eine Strukturierung mit Erhebungen und Vertiefungen aufweist und die erste Polymerfolie (1) mit der zweiten Polymerfolie (1', 5) derart verbunden ist, dass zwischen den Polymerfolien, (1) (1', 5) ein oder mehrere Hohlräume (4) ausgebildet sind und weiterhin die inneren Oberflächen der ausgebildeten Hohlräume (4) mit entgegengesetzten elektrischen Ladungen versehen sind.

**13.** Ferroelektret Zwei- oder Mehrschichtverbund nach Anspruch 12 **dadurch gekennzeichnet, dass** die Form der Querschnittsflächen der Hohlräume parallel und senkrecht zum Schichtverlauf der Polymerfolien, unabhängig voneinander, teilweise oder vollständig ausgewählt sind aus regelmäßigen und unregelmäßigen, runden, elliptischen oder ovalen, polygonen, wabenförmigen, kreuzförmigen, sternförmigen und teilweise runden und teilweise polygonen Formen.

**14.** Piezoelektrisches Element enthaltend mindestens einen Ferroelektret Zwei- oder Mehrschichtverbund nach Anspruch 12 und/oder mindestens einen Ferroelektret Zwei-oder Mehrschichtverbund hergestellt nach einem Verfahren gemäß Anspruch 1.

**15.** Vorrichtung zur Durchführung des Verfahrens nach Anspruch 1, **dadurch gekennzeichnet, dass** sie Mittel zur Strukturierung mindestens einer Oberfläche einer ersten Polymerfolie umfasst.

FIG. 1

FIG. 2

FIG. 3a

FIG. 3b

FIG. 3c

FIG. 3d

FIG. 4a

FIG. 4b

FIG. 4c

FIG. 4d

FIG. 4e

FIG. 4f

FIG. 4g

FIG. 5

Europäisches
Patentamt
European
Patent Office
Office européen
des brevets

## EUROPÄISCHER RECHERCHENBERICHT

Nummer der Anmeldung

EP 09 00 9203

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | ALTAFIM RUY ET AL: "Template-based fluoroethylenepropylene piezoelectrets with tubular channels for transducer applications" 9. Juli 2009 (2009-07-09), JOURNAL OF APPLIED PHYSICS, AMERICAN INSTITUTE OF PHYSICS. NEW YORK, US LNKD-DOI:10.1063/1.3159039, PAGE(S) 14106 - 14106 , XP012123453 ISSN: 0021-8979 * II.SAMPLE PREPARATION; IV. CONCLUSION; Seiten 01406-3, rechte Spalte; Abbildungen 1,4 *   ----- | 12-14 | INV. B32B3/30 B06B1/02 H04R17/02 H04R23/00 H01L41/08 H01L41/083 H04R17/00 |
| X,D | ZHANG X ET AL: "Thermally stable fluorocarbon ferroelectrets with high piezoelectric coefficient" APPLIED PHYSICS A; MATERIALS SCIENCE & PROCESSING, SPRINGER, BERLIN, DE LNKD-DOI:10.1007/S00339-006-3573-5, Bd. 84, Nr. 1-2, 7. April 2006 (2006-04-07), Seiten 139-142, XP019424358 ISSN: 1432-0630 * Introduction; Preparation of the fused films;Abbildungen 1a,1b, *   ----- | 12-14 | |
| X,D | DE 32 28 002 A1 (NAUTA ROLL CORP [US]) 3. Februar 1983 (1983-02-03) * Seite 1, Zeile 1 - Seite 4, Zeile 4; Ansprüche *   ----- | 15 | RECHERCHIERTE SACHGEBIETE (IPC)  B32B B06B H04R H01L |
| X,D | DE 39 05 177 B4 (NIEBLING CURT [DE] BAYER MATERIALSCIENCE AG [DE]) 2. Dezember 2004 (2004-12-02) * das ganze Dokument *   ----- | 15 | |

Der vorliegende Recherchenbericht wurde für alle Patentansprüche erstellt

| Recherchenort | Abschlußdatum der Recherche | Prüfer |
|---|---|---|
| München | 16. Juni 2010 | Kanetakis, Ioannis |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 09 00 9203

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-06-2010

| Im Recherchenbericht angeführtes Patentdokument | Datum der Veröffentlichung | Mitglied(er) der Patentfamilie | Datum der Veröffentlichung |
|---|---|---|---|
| DE 3228002 A1 | 03-02-1983 | CA 1184078 A1<br>US 4368240 A | 19-03-1985<br>11-01-1983 |
| DE 3905177 B4 | 02-12-2004 | DE 3905177 A1 | 23-08-1990 |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2006053528 A1
- US 4654546 A
- DE 3905177 A1
- US 4368240 A

**In der Beschreibung aufgeführte Nicht-Patentliteratur**

- **M. Wegener ; M. Paajanen ; O. Voronina ; R. Schulze ; W. Wirges ; R. Gerhard-Multhaupt.** Voided cyclo-olefin polymer films: Ferroelectrets with high thermal stability. *Proceedings, 12th International Symposium on Electrets,* 2005, 47-50
- **Eetta Saarimäki ; Mika Paajanen ; Ann-Mari Savijärvi ; Hannu Minkkinen ; Michael Wegener ; Olena Voronina ; Robert Schulze ; Werner Wirges ; Reimund Gerhard-Multhaupt.** Novel Heat Durable Electromechanical Film: Processing for Electromechanical and Electret Applications. *IEEE Transactions on Dielectrics and Electrical Insulation,* Oktober 2006, vol. 13, 963-972
- *Advanced Functional Materials,* 2007, vol. 17, 324-329
- **Werner Wirges ; Michael Wegener ; Olena Voronina ; Larissa Zirkel ; Reimund Gerhard-Multhaupt.** Optimized preparation of elastically soft, highly piezoelectric, cellular ferroelectrets from nonvoided poly(ethylene terephthalate) films. *Optimized preparation of elastically soft, highly piezoelectric, cellular ferroelectrets from nonvoided poly(ethylene terephthalate) films*
- **P. Fang ; M. Wegener ; W. Wirges ; R. Gerhard ; L. Zirkel.** Cellular polyethylene-naphthalate ferroelectrets: Foaming in supercritical carbon dioxide, structural and electrical preparation, and resulting piezoelectricity. *Applied Physics Letters,* 2007, vol. 90, 192908
- **O. Voronina ; M. Wegener ; W. Wirges ; R. Gerhard ; L. Zirkel ; H. Münstedt.** Physical foaming of fluorinated ethylene-propylene (FEP) copolymers in supercritical carbon dioxide: single film fluoropolymer piezoelectrets. *Applied Physics A: Materials Science & Processing,* 2008, vol. 90, 615-618
- **R. Kacprzyk ; A. Dobrucki ; J. B. Gajewski.** Double-layer electret transducer. *Journal of Electrostatics,* 1997, vol. 39, 33-40
- **Z. Hu ; H. von Seggern.** Air-breakdown charging mechanism of fibrous polytetrafluoroethylene films. *Journal of Applied Physics,* 2005, vol. 98
- Breakdown-induced polarization buildup in porous fluoropolymer sandwiches: A thermally stable piezoelectret. *Journal of Applied Physics,* 2005, vol. 99
- **H.C. Basso ; R.A.P. Altafilm ; R.A.C. Altafilm ; A. Mellinger ; Peng Fang ; W. Wirges ; R. Gerhard.** Three-layer ferroelectrets from perforated Teflon-PTFE films fused between two homogeneous Teflon-FEP films. *IEEE, 2007 Annual Report Conference on Electrical Insulation and Dielectric Phenomena,* 2007, 453-456
- **Jinfeng Huang ; Xiaoqing Zhang ; Zhongfu Xia ; Xuewen Wang.** Piezoelectrets from laminated sandwiches of porous polytetrafluoroethylene films and nonporous fluoroethylenepropylene films. *Journal of Applied Physics,* 2008, vol. 103
- **X. Zhang ; J. Hillenbrand ; G. M. Sessler.** Thermally stable fluorocarbon ferroelectrets with high piezoelectric coefficient. *Applied Physics A,* 2006, vol. 84, 139-142
- Ferroelectrets with improved thermal stability made from fused fluorocarbon layers. *Journal of Applied Physics,* 2007, vol. 101
- **Xiaoqing Zhang ; Jinfeng Huang ; Zhongfu Xia.** Piezoelectric activity and thermal stability of cellular fluorocarbon films. *PHYSICA SCRIPTA,* 2007, vol. T129, 274-277
- **R. A. C. Altafim ; H. C. Basso ; R. A. P. Altafim ; L. Lima ; C. V. De Aquino ; L. Gonalves Neto ; R. Gerhard-Multhaupt.** Piezoelectrets from thermo-formed bubble structures of fluoropolymer-electret films. *IEEE Transactions on Dielectrics and Electrical Insulation,* 2006, vol. 13 (5), 979-985
- **R. A. P. Altafim ; X. Qiu, W. Wirges ; R. Gerhard ; R. A. C. Altafim ; H.C. Basso ; W. Jenninger ; J. Wagner.** Template-based fluoroethylenepropylene piezoelectrets with tubular channels for transducer applications. *Journal of Applied Physics*